(19) Europäisches Patentamt
European Patent Office
Office européen des brevets

(11) **EP 4 278 482 B1**

(12) **EUROPEAN PATENT SPECIFICATION**

(45) Date of publication and mention
of the grant of the patent:
**01.01.2025 Bulletin 2025/01**

(21) Application number: **21715988.8**

(22) Date of filing: **01.03.2021**

(51) International Patent Classification (IPC):
**H03F 3/189** (2006.01)        **H03F 3/22** (2006.01)
**H04B 10/2507** (2013.01)        **H03F 1/32** (2006.01)
**H04B 10/58** (2013.01)        **H03F 3/24** (2006.01)

(52) Cooperative Patent Classification (CPC):
**H04B 10/58; H03F 1/3241; H03F 1/3294;
H03F 3/189; H03F 3/24; H04B 10/2507;**
H03F 2200/451

(86) International application number:
**PCT/RU2021/000087**

(87) International publication number:
**WO 2022/186711 (09.09.2022 Gazette 2022/36)**

(54) **METHOD AND APPARATUS FOR PREDISTORTION OF A DIGITAL SIGNAL IN A TRANSMITTER CHAIN**

VERFAHREN UND VORRICHTUNG ZUR VORVERZERRUNG EINES DIGITALEN SIGNALS IN EINER SENDERKETTE

PROCÉDÉ ET APPAREIL DE PRÉDISTORSION D'UN SIGNAL NUMÉRIQUE DANS UNE CHAÎNE D'ÉMETTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.11.2023 Bulletin 2023/47**

(73) Proprietor: **Huawei Technologies Co., Ltd.
Shenzhen, Guangdong 518129 (CN)**

(72) Inventors:
• **SIDELNIKOV, Gleb Borisovich
Shenzhen Guangdong, 518129 (CN)**

• **LUO, Ji
Shenzhen Guangdong, 518129 (CN)**
• **MORYAKOVA, Oksana Alekseevna
Shenzhen Guangdong, 518129 (CN)**

(74) Representative: **Epping - Hermann - Fischer
Patentanwaltsgesellschaft mbH
Schloßschmidstraße 5
80639 München (DE)**

(56) References cited:
**EP-A1- 3 457 594        US-A1- 2005 195 919**

**Description**

**TECHNICAL FIELD**

The disclosure relates generally to a digital signal predistortion, and more particularly, to a method and an apparatus for predistortion of a digital signal in a transmitter chain.

**BACKGROUND**

An application of a digital pre-compensation in a transmitter has been known in optics for reducing a penalty introduced by non-linear components such as a power amplifier, PA, and an in-phase and quadrature modulator, IQM. The power amplifiers, PA, are essential components in overall performance and throughput of communication systems, but the power amplifiers are inherently nonlinear. The nonlinearity in the power amplifiers generates spectral re-growth, which leads to adjacent channel interference and violations of out-of-band emissions standards mandated by regulatory bodies. The nonlinearity in the power amplifiers also causes in-band distortion, which degrades a bit-error-rate, BER, and data throughput of a communication system. The digital pre-compensation eliminates the non-linear effects and helps to relax specifications of main modules of the transmitter thus lowering its overall costs. A transmission of high-order modulation formats is enabled by the digital pre-compensation which thereby increases spectral efficiency of the communication system. The use of the digital pre-compensation further allows transmitting signals with different and higher symbol rates, which in turn allows employing different forward error correction, FEC, overheads so that the transmission can be adapted to parameters of a link.

The digital pre-compensation is applied in the transmitter and/or a receiver as part of a digital signal processing. In particular, the digital pre-compensation can be applied for mitigating a penalty caused by a limited electrical bandwidth of the transmitter and for reducing an impact of non-linear characteristics of IQM and/or PAs. There are different known methods of digital pre-compensation with different complexity and performance based on a feed-forward digital pre-emphasis, PE, and a digital predistortion, DPD. In the PE, a linear filter is applied, while the DPD nonlinearly pre-distorts an input signal. The DPD methods aim to copy a non-linear behaviour of the limiting components and inject the transmitted signal with an inverse of the non-linear function to linearize an output. The known DPD methods are mainly of two types. DPD methods of a first type, hereinafter - DPD-1, operate on 1 sample per symbol, SPS, signals. Computational complexity (hereinafter, a time complexity is referred to as the computational complexity or simply complexity, that is expressed as the number of required elementary operations on an input of size N, where elementary operations are assumed to take a constant amount of time on a given computer and change only by a constant factor when run on a different computer) of the DPD processing in this case is advantageously low, but DPD methods of this type has a limited performance as an upsampling is performed after the digital predistortion processing of an input signal and an 1 SPS feedback error signal is used for the pre-distortion algorithm adaptation.

DPD methods of a second type, hereinafter - DPD-2, operate on upsampled signals with a higher SPS, including the use of a high SPS feedback error signal, that provides for a higher performance of the communication system. The DPD methods of the second type are used when the high performance is of particular importance. However, the DPD processing in this case has a significantly higher complexity and thereby higher implementation costs.

In general, the performance of the known digital pre-compensation methods is limited by a level of complexity of the required processing. The known DPD methods do not allow achieving a higher performance of the system under the condition of low complexity of the digital signal processing.

Therefore, there arises a need to address the above-mentioned technical drawbacks in existing technologies to ensure an improved performance of a communication system with a digital predistortion while maintaining the complexity of the signal processing low.

US20050195919A1 discloses a digital predistorter, comprising: an input for receiving a digital communication signal comprising a stream of signal samples; a linear dynamic compensation circuit coupled to the input and providing a linear operation on a plurality of time delayed signal samples; a digital envelope detector coupled to the input and providing a stream of discrete digital envelope signal samples corresponding to the input signal samples; a finite impulse response filter coupled to the envelope detector and providing a first nonlinear operation on a plurality of delayed envelope signal samples; an infinite impulse response filter bank coupled to the envelope detector in parallel with said finite impulse response filter and providing a second nonlinear operation on plural delayed envelope samples; and a combiner for combining the outputs of the linear dynamics compensation circuit, finite impulse response filter and infinite impulse response filter bank and providing a digital predistortion signal as an output.

EP3457594A1 discloses a method for determining a model representation for an optical transmitter comprises determining a quantity of a subsequence of output signals of an optical transmitter, the output signals being emitted in response to a sequence of input signals provided to the optical transmitter, and determining a model representation for the optical transmitter based on the determined quantity, wherein the quantity only represents a part of the information encoded in the subsequence of the output signals.

**SUMMARY**

It is an object of the disclosure to provide a method and an apparatus for predistortion of a digital signal in a transmitter chain avoiding one or more disadvantages of the prior art.

This object is achieved by features of the independent claims. Further implementation forms are apparent from the dependent claims, the description, and the figures.

The disclosure provides a method and an apparatus for predistortion of a digital signal in a transmitter chain.

According to a first aspect, there is provided a method of predistortion of a digital signal in a transmitter chain. The method comprises obtaining an input signal sampled at a first sampling rate. The method then comprises decomposing the input signal into k down input signal subsets of equal length L by sequentially assigning each k_down-th sample of the input signal, starting with an l-th sample, to an l-th input signal subset in ascending order of sample number, where L, k down and l are integers, l being from l to k down. The method further comprises generating k_down model input signal subsets of equal length L, by applying a non-linear model to each of the k_down input signal subsets. The method also comprises generating k_up predistortion signal subsets of equal length L. Each predistortion signal subset is generated by combining the k_down model input signal subsets. Each model input signal subset being multiplied by an adaptation coefficient, where k_up is an integer greater than k_down. The method then comprises generating a predistortion signal with a second sampling rate which is k_up/ k_down times the first sampling rate by sequentially assigning one sample from each predistortion signal subset, in ascending order of subset number, from 1 to k_up, to the predistortion signal until all samples of the k_up predistortion signal subsets are assigned.

The predistortion method as described, on one hand, operates on a low SPS input signals, but on the other hand, it has a polyphase structure, where the input signal is decomposed into a plurality of subsets or phases of equal length which are processed separately, that provides for embedding the upsampling into the predistortion process itself. The method advantageously provides for upsampling of the digital signal with different upsampling factors, including float factors, as a part of the predistortion processing. The method thereby allows improving the overall system performance while maintaining the complexity of the digital signal processing low.

Optionally, the method comprises obtaining an error signal sampled at the second sampling rate, decompressing the error signal into k_up error signal subsets of equal length L by sequential assigning each k_up-th sample of the error signal, starting with an p-th sample, to an p-th error signal subset in ascending order of sample number, p being from 1 to k_up, and calculating k_up*k_down adaptation coefficients for the k_down model input signal subsets on the basis of the k_up error signal subset.

Each predistortion signal subset can be generated by summing up the k_down model input signal subsets, wherein each model input signal subset is multiplied by an adaptation coefficient.

Thereby, the predistortion method is fed back with a higher SPS error signal to improve the performance, but again, uses the polyphase structure, where the feedback error signal is decomposed into a plurality of subsets or phases of the same equal length to be processed separately, that provides for maintaining the complexity low.

The method can comprise determining, for each predistortion signal subset, the biggest adaptation coefficient among k down adaptation coefficients of the k_down model input signal subsets to be combined for generating the given predistortion signal subset, and selecting a model input signal subset with the biggest adaptation coefficient as an only term that contributes to the given predistortion signal subset.

The first sampling rate can be 1 sample per second, SPS. In this case, the non-liner model can be a non-linear spline model. Furthermore, the applying of the non-linear spline model can comprise calculating spline functions using lookup tables.

According to a second aspect, there is provided an apparatus for predistortion of a digital signal in a transmitter chain. The apparatus comprises a feeder, a decomposer, an evaluator, a predistortion unit and a composer. The feeder is configured for obtaining an input signal sampled at a first sampling rate. The decomposer is configured for decomposing the input signal into k_down input signal subsets of equal length L by sequentially assigning each k_down-th sample of the input signal, starting with an l-th sample, to an l-th input signal subset in ascending order of sample number, where L, k_down and l are integers, l being from 1 to k_down. The evaluator is configured for generating k_down model input signal subsets of equal length L, by applying a non-linear model to each of the k_down input signal subsets. The predistortion unit is configured for generating k_up predistortion signal subsets of equal length L. Each predistortion signal subset is generated by combining the k down model input signal subsets, wherein each model input signal subset is multiplied by an adaptation coefficient. K_up is an integer greater than k down. The composer is configured for generating a predistortion signal with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned.

The predistortion apparatus of the second aspect implements the predistortion method of the first aspect and provides for achieving all the effects and benefits thereof. The predistortion apparatus operates on a low SPS input signal and has the polyphase structure, where the input signal is decomposed into a plurality of subsets or phases of equal length which are processed separately, that provides for embedding the upsampling into the predistortion process itself. The apparatus advantageously provides for upsampling of the digital signal with different upsampling factors, including float factors, as a part of the predistortion processing. The apparatus thereby allows improving the overall system performance while maintaining the complexity of the digital signal processing low. The apparatus can be based on relatively low-cost hardware for generating nonlinear distortions.

Optionally, the apparatus comprises a feedback feeder and a feedback decomposer. The feedback feeder is configured for obtaining an error signal sampled at the second sampling rate. The feedback decomposer is configured for decompressing the error signal into k_up error signal subsets of equal length L by sequential assigning each k_up-th sample of the error signal, starting with an p-th sample, to an p-th error signal subset in ascending order of sample number, p being from 1 to k_up. The predistortion unit can be further configured for calculating k_up*k_down adaptation coefficients for the k_down model input signal subsets on the basis of the k_up error signal subsets.

Optionally, the feedback feeder is configured for receiving an upsampled input signal having the second sampling rate from an upsampling unit, and a feedback signal sampled at the second sampling rate from a receiver chain, and summing up the upsampled input signal with the inverted feedback signal to obtain the error signal sampled at the second sampling rate.

The predistortion apparatus with the feedback decomposer as described enables the use of a higher SPS feedback error signal to improve the performance without a significant increase in the complexity. This is provided by the polyphase structure, where the feedback error signal is decomposed into a plurality of subsets or phases of the same equal length to be processed separately, that provides for maintaining the complexity low. The described configuration of the predistortion apparatus also allows conducting the upsampling and the digital pre-emphasis, PE, of the signal in parallel with the predistortion to further reduce the complexity of the digital signal processing in the transmitter.

Alternative to the above, the feedback feeder can be configured for receiving the input signal having the first sampling rate from the feeder and a feedback signal sampled at the first sampling rate from a receiver chain, summing up the input signal with the inverted feedback signal, each having the first sampling rate, to obtain the error signal having the first sampling rate, and upsampling the error signal to the second sampling rate to obtain the error signal sampled at the second sampling rate.

Optionally, the predistortion unit can be configured for generating each predistortion signal subset by summing up the k_down model input signal subsets, wherein each model input signal subset is multiplied by an adaptation coefficient. Alternative to the latter, the predistortion unit can be configured for determining, for each predistortion signal subset, the biggest adaptation coefficient among k down adaptation coefficients of the k_down model input signal subsets to be combined for generating the given predistortion signal subset, and selecting a model input signal subset with the biggest adaptation coefficient as an only term that contributes to the given predistortion signal subset. The rest of the k_down adaptation coefficients, except for the biggest one, can be discarded which allows reducing the complexity significantly with a minor impact in the performance.

The first sampling rate can be 1 sample per second, SPS. In this case, the evaluator can be configured for applying a non-linear spline model. The evaluator can be further configured for calculating spline functions of the non-linear spline model using lookup tables. The use of the spline functions ant the lookup tables allows further improving the performance while decreasing the complexity.

According to a third aspect, there is provided a method of predistortion of a digital signal in a transmitter chain. The method comprises obtaining an input signal sampled at a first sampling rate. The method then comprises decomposing the input signal into k_down input signal subsets of equal length L by sequentially assigning each k_down-th sample of the input signal, starting with an l-th sample, to an l-th input signal subset in ascending order of sample number, where L, k_down and l are integers, l being from 1 to k_down. The method further comprises generating k_down groups of 3 model input signal subsets of equal length L, by applying a non-linear spline model to every input signal subset to generate a group of 3 model input signal subsets from every input signal subset. Each group comprises (i) a product of an input signal subset shifted by a first index and two spline functions of a real part of the input signal subset shifted by a second index and of an imaginary part of the input signal subset shifted by a third index, (ii) a product of the input signal subset shifted by the first index and two spline functions of two real parts of the input signal subset shifted by the second index and by the third index, and (iii) a product of the input signal subset shifted by the first index and two spline functions of two imaginary parts of the input signal subset shifted by the second index and by the third index. The method also comprises generating k_up predistortion signal subsets of equal length L. Each predistortion signal subset is generated by combining the k_down groups of 3 model input signal subsets, wherein each model input signal subset is multiplied by an adaptation coefficient. The k_up is an integer greater than k_down. The method also comprises generating a predistortion signal with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned.

The predistortion method of the third aspect provides for all the effects and advantages of the predistortion method of the first aspect and allows further decreasing the complexity due to the use of the spline model and possible use of lookup tables to calculate the spline functions as described below.

The method can further comprise obtaining an error signal sampled at the second sampling rate, decompressing the error signal into k_up error signal subsets of equal length L by sequential assigning each k_up-th sample of the error signal, starting with an p-th sample, to an p-th error signal subset in ascending order of sample number, p being from 1 to k_up, and calculating k_up*k_down groups of 3 adaptation coefficients for the 3 model input signal subsets on the basis of the k_up error signal subset.

Optionally, each predistortion signal subset can be obtained by summing up the k_down groups of 3 model input signal subsets, each model input signal subset being multiplied by an adaptation coefficient.

Alternative to the above, the method can comprise determining, for each predistortion signal subset, a group of 3 adaptation coefficients having the biggest values among k_down groups of 3 adaptation coefficients of the k_down groups of 3 model input signal subsets to be combined for generating the given predistortion signal subset, and selecting a group of 3 model input signal subsets with the adaptation coefficients of the biggest values as an only term that contributes to the given predistortion signal subset.

The first sampling rate can be 1 sample per second, SPS. Also, the applying of the non-linear spline model can comprise calculating the spline functions using lookup tables.

According to a fourth aspect, there is provided an apparatus for predistortion of a digital signal in a transmitter chain. The apparatus comprises a feeder, a decomposer, an evaluator, a predistortion unit and a composer. The feeder is configured for obtaining an input signal sampled at a first sampling rate. The decomposer is configured for decomposing the input signal into k_down input signal subsets of equal length L by sequentially assigning each k_down-th sample of the input signal, starting with an l-th sample, to an l-th input signal subset in ascending order of sample number, where L, k_down and l are integers, l being from 1 to k_down. The evaluator is configured for generating k_down groups of 3 model input signal subsets of equal length L, by applying a non-linear model to every input signal subset to generate a group of 3 model input signal subsets from every input signal subset. Each group comprises (i) a product of an input signal subset shifted by a first index and two spline functions of a real part of the input signal subset shifted by a second index and of an imaginary part of the input signal subset shifted by a third index, (ii) a product of the input signal subset shifted by the first index and two spline functions of two real parts of the input signal subset shifted by the second index and by the third index, and, (iii) a product of the input signal subset shifted by the first index and two spline functions of two imaginary parts of the input signal subset shifted by the second index and by the third index. The predistortion unit is configured for generating k_up predistortion signal subsets of equal length L. Each predistortion signal subset is generated by combining the k_down groups of 3 model input signal subsets. Each model input signal subset is being multiplied by an adaptation coefficient, where k_up is an integer greater than k_down. The composer is configured for generating a predistortion signal with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned.

The predistortion apparatus of the fourth aspect implements the predistortion method of the third aspect and provides for achieving all the effects and benefits thereof. The apparatus in this case can also be based on relatively low-cost hardware for generating nonlinear distortions.

The apparatus can further comprise a feedback feeder and a feedback decomposer. The feedback feeder is configured for obtaining an error signal sampled at the second sampling rate. The feedback decomposer is configured for decompressing the error signal into k_up error signal subsets of equal length L by sequential assigning each k_up-th sample of the error signal, starting with an p-th sample, to an p-th error signal subset in ascending order of sample number, p being from 1 to k_up. The predistortion unit can be further configured for calculating k_up*k_down groups of 3 adaptation coefficients for the k_down groups of 3 model input signal subsets on the basis of the k_up error signal subsets.

The feedback feeder can be configured for receiving an upsampled input signal having the second sampling rate from an upsampling unit, and a feedback signal sampled at the second sampling rate from a receiver chain, and summing up the upsampled input signal with the inverted feedback signal to obtain the error signal sampled at the second sampling rate. Alternative to the latter, the feedback feeder can be configured for receiving the input signal having the first sampling rate from the feeder and a feedback signal sampled at the first sampling rate from a receiver chain, summing up the input signal with the inverted feedback signal, each having the first sampling rate, to obtain the error signal having the first sampling rate, and upsampling the error signal to the second sampling rate to obtain the error signal sampled at the second sampling rate.

Optionally, the predistortion unit can be configured for generating each predistortion signal subset by summing up the k_down groups of 3 model input signal subsets, each model input signal subset being multiplied by an adaptation coefficient.

Alternative to the latter, the predistortion unit can be configured for determining, for each predistortion signal subset, a group of 3 adaptation coefficients having the biggest values among k_down groups of 3 adaptation coefficients of the k_down groups of 3 model input signal subsets to be combined for generating the given predistortion signal subset, and selecting a group of 3 model input signal subsets with the adaptation coefficients of the biggest values as an only term that contributes to the given predistortion signal subset.

The first sampling rate can be 1 sample per second, SPS. At that, the evaluator can be configured for calculating spline functions of the non-linear spline model using lookup tables.

A technical problem of the prior art is solved with any of the methods and the apparatuses as described above, wherein the technical problem concerns limitations in existing communication systems, such as low performance and high complexity of the digital signal predistortion.

The present disclosure provides for embedding the upsampling into the predistortion process by means of the polyphase structure of the described predistortion methods and apparatuses which allows improving the performance of the digital signal processing while maintaining the complexity low. The methods and the apparatuses as disclosed can be implemented with different upsampling factors within the predistortion processing. Therefore, the use of the methods and the apparatuses as disclosed can reduce a penalty introduced to a communication system by non-liner characteristics of components, such as power amplifiers, PA, and in-phase and quadrature modulator, IQM, in an optimized and effective manner.

These and other aspects of the disclosure will be apparent from the implementation(s) described below.

## BRIEF DESCRIPTION OF DRAWINGS

Implementations of the disclosure will now be described, by way of example only, with reference to the accompanying drawings in which:

FIG. 1A is a block diagram of an apparatus for predistortion of a digital signal in a transmitter chain in accordance with an implementation of the disclosure;

FIG. 1B is a block diagram of an apparatus for predistortion of a digital signal in a transmitter chain in accordance with another implementation of the disclosure;

FIGS. 2A-2B illustrate decomposing of an input signal into subsets or phases in accordance with implementations of the disclosure;

FIGS. 3A-3B illustrate decomposing of an error signal into subsets or phases in accordance with implementations of the disclosure;

FIGS. 4A-4B are diagrams that illustrate generating predistortion signal subsets in accordance with implementations of the disclosure;

FIG. 5 illustrates merging predistortion signal subsets into a predistortion signal in accordance with an implementation of the disclosure;

FIGS. 6A-6B are block diagrams that illustrate a communication system with an apparatus for predistortion of the digital signal in a transmitter chain in accordance with implementations of the disclosure;

FIG. 7 is a flow diagram of a method of predistortion of a digital signal in a transmitter chain in accordance with an implementation of the disclosure;

FIG. 8 is a flow diagram of a method of predistortion of a digital signal in a transmitter chain in accordance with another implementation of the disclosure;

FIG. 9A is a graph illustrating a comparative data on the performance of the known digital predistortion methods (DPD-1 and DPD-2) and the Upsampling Digital Predistortion, UDPD, method in accordance with an implementation of the disclosure with a predistortion upsampling factor of 1.5;

FIG. 9B is a graph illustrating a comparative data on the performance of the known digital predistortion methods (DPD-1 and DPD-2) and the UDPD method in accordance with an implementation of the disclosure with a predistortion upsampling factor of 1.25;

FIG. 9C is a graph illustrating a comparative data on the performance of the known digital predistortion methods (DPD-1 and DPD-2) and the UDPD method in accordance with an implementation of the disclosure with a predistortion upsampling factor of 2.0.

## DETAILED DESCRIPTION

Implementations of the disclosure provide methods and apparatuses for predistortion of a digital signal in a transmitter chain to improve the performance of the digital signal processing while maintaining the complexity low.

To make solutions of the disclosure more comprehensible for a person skilled in the art, the following implementations of the disclosure are described with reference to the accompanying drawings.

Terms such as "a first", "a second", "a third", and "a fourth" (if any) in the summary, claims, and the accompanying drawings of the disclosure are used to distinguish between similar objects and are not necessarily used to describe a specific sequence or order. It should be understood that the terms so used are interchangeable under appropriate circumstances, so that the implementations of the disclosure described herein are, for example, capable of being implemented in sequences other than the sequences illustrated or described herein. Furthermore, the terms "comprise" and "have" and any variations thereof, are intended to cover a non-exclusive inclusion. For example, a process, a method, a system, a product, or a device that comprises a series of steps or units, is not necessarily limited to expressly listed steps or units, but it can comprise other steps or units that are not expressly listed or that are inherent to such process, method, product, or device.

Definitions:

DPD: Digital Pre-Distortion is one of the most cost-effective linearization techniques. It features an excellent linearization capability, the ability to preserve overall efficiency, and it takes full advantage of advances in digital signal processors and A/D converters. The technique adds an expanding nonlinearity in the baseband that complements the compressing characteristic of the radio frequency power amplifier. Ideally, the cascade of the predistorter and the power amplifier becomes linear and the original input is amplified by a constant gain. With a predistorter, the power amplifier can be utilized up to its saturation point while still maintaining good linearity, thereby significantly increasing its efficiency.

Upsampling: In digital signal processing upsampling is a term associated with the process of resampling in a multi-rate digital signal processing system. Upsampling can be synonymous with expansion, or it can describe an entire process of expansion and filtering (interpolation). When upsampling is performed on a sequence of samples of a signal or other continuous function, it produces an approximation of the sequence that would have been obtained by sampling the signal at a higher rate.

Downsampling: In digital signal processing, downsampling is a term associated with the process of resampling in a multi-rate digital signal processing system. Both downsampling and decimation can be synonymous with compression, or they can describe an entire process of bandwidth reduction (filtering) and sample-rate reduction. When the process is performed on a sequence of samples of a signal or other continuous function, it produces an approximation of the sequence that would have been obtained by sampling the signal at a lower rate.

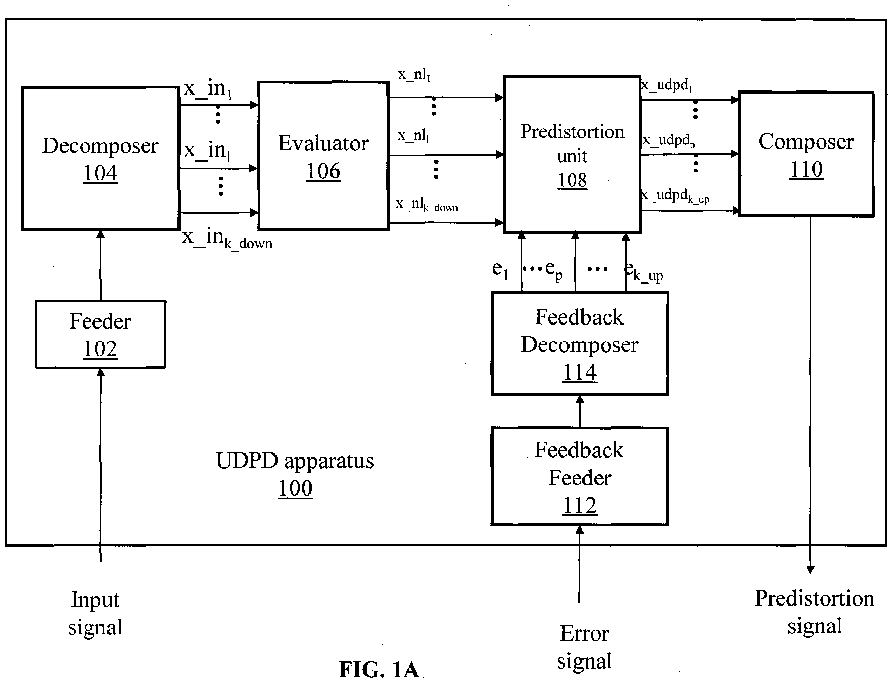

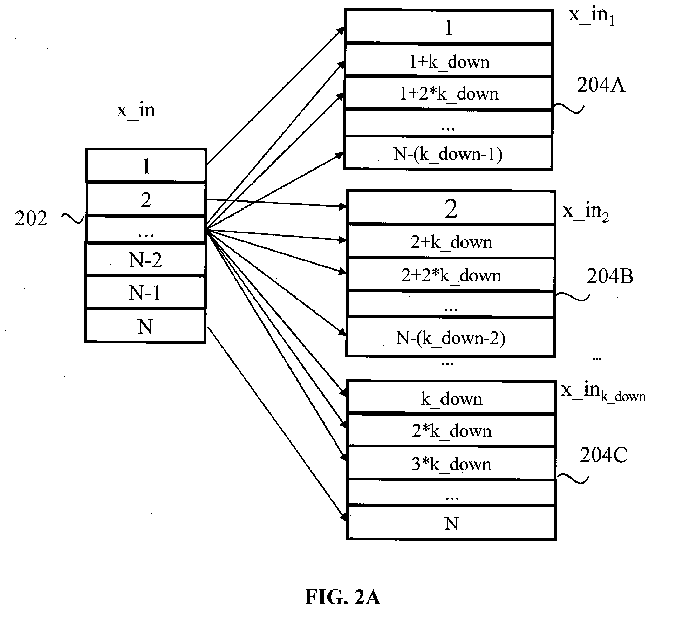

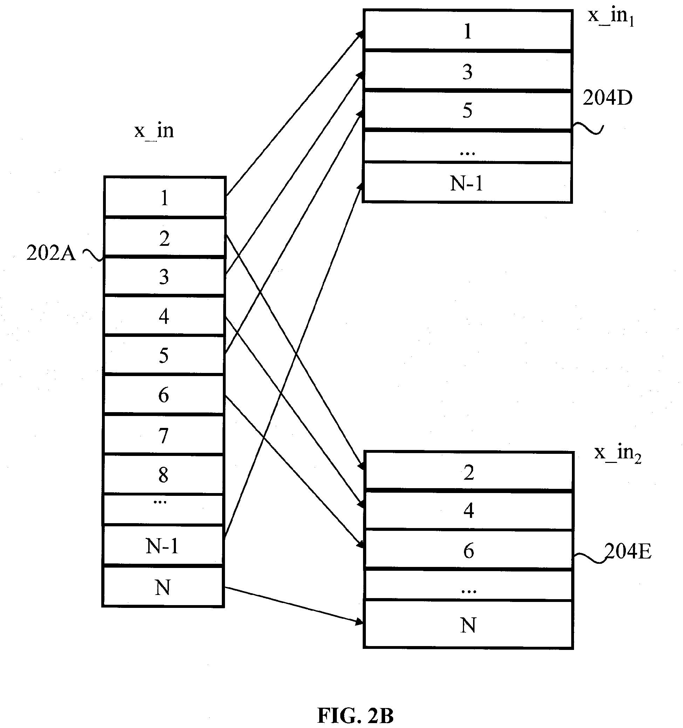

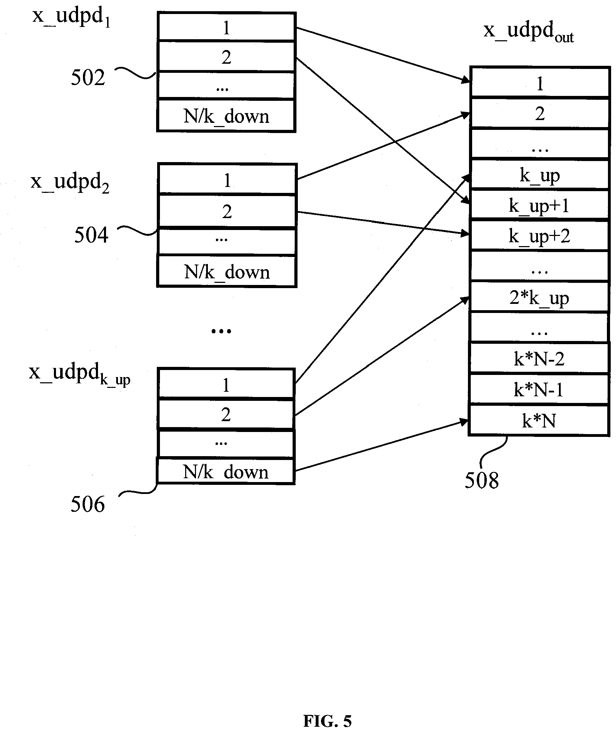

FIG. 1A is a block diagram of an apparatus **100** for predistortion of a digital signal in a transmitter chain which can be referred to as an upsampling digital predistortion, UDPD, apparatus **100**. The UDPD apparatus **100** comprises a feeder **102**, a decomposer **104**, an evaluator **106**, a predistortion unit **108** and a composer **110**. The feeder **102** is configured for obtaining an input signal sampled at a first sampling rate, having a length of N, i.e. including N samples. The decomposer **104** is configured for decomposing the input signal into k down input signal subsets of equal length L by sequentially assigning each k_down-th sample of the input signal, starting with an l-th sample, to an l-th input signal subset in ascending order of sample number, where L, k_down and l are integers, l being from 1 to k_down. The decomposing as described is illustrated in FIGS. 2A and 2B. K down can be referred to as a downsampling factor, wherein L is N/k_down. The evaluator **106** is configured for generating k_down model input signal subsets of equal length L, by applying a non-linear model to each of the k_down input signal subsets. The predistortion unit **108** is configured for generating k_up predistortion signal subsets of equal length L. Each predistortion signal subset is generated by combining the k_down model input signal subsets multiplied each by an adaptation coefficient. K_up is an integer greater than k_down and can be referred to as an upsampling factor. The composer **110** is configured for generating a predistortion signal, which has a second sampling rate which is k_up/k_down times the first sampling rate, by sequentially assigning one sample from each predistortion signal subset, in ascending order of subset number, from 1 to k_up, to the predistortion signal until all samples of the k_up predistortion signal subsets are assigned. The generating of the predistortion signal from the predistortion signal subsets is illustrated in FIG.5. The ratio k = k_up/k_down can be referred to as a predistortion upsampling factor. The first sampling rate is a low SPS rate such as 1 SPS.

The UDPD apparatus **100** operates on a low SPS input signal and has the polyphase structure, where the input signal is decomposed into a plurality of subsets or phases of equal length which are processed separately, that provides for embedding the upsampling into the predistortion process itself. The UDPD apparatus **100** advantageously provides for upsampling of the digital signal with different upsampling factors k = k_up/k_down, including float factors, as a part of the predistortion processing. The UDPD apparatus **100** thereby allows improving the overall system performance while maintaining the complexity of the digital signal processing low. The UDPD apparatus **100** can be based on relatively low-cost hardware for generating nonlinear distortions.

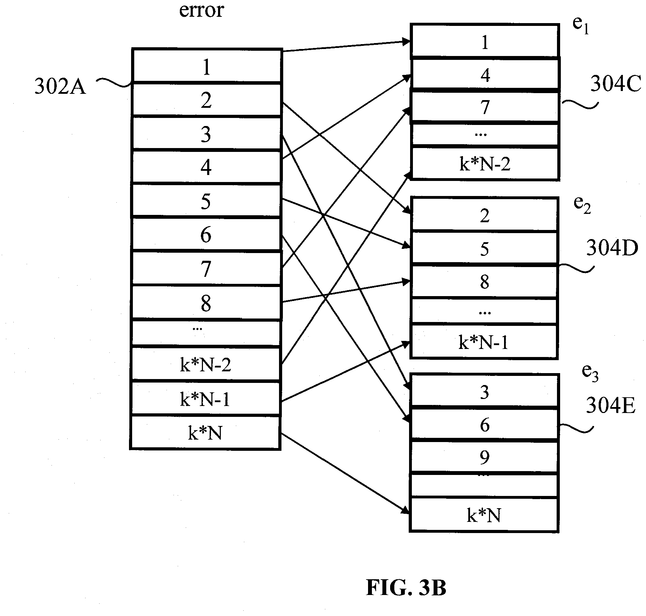

The UDPD apparatus **100** further comprises a feedback feeder **112** and a feedback decomposer **114**. The feedback feeder **112** is configured for obtaining an error signal sampled at the second sampling rate, having a length of k*N, i.e. including k*N samples, where k is the predistortion upsampling factor equal to k_up/k_down. The feedback decomposer **114** is configured for decompressing the error signal into k_up error signal subsets of equal length L by sequential assigning each k up-th sample of the error signal, starting with an p-th sample, to an p-th error signal subset in ascending order of sample number, p being from 1 to k_up. The decompressing of the error signal is illustrated in FIGS. 3A and 3B. The predistortion unit **108** is further configured for calculating k_up*k_down adaptation coefficients for the k_down model input signal subsets on the basis of the k_up error signal subsets.

The predistortion upsampling coefficient k equal to k_up/k_down is a floating-point number and can have different values depending on requirements and needs of the system performance. For example, the predistortion upsampling coefficient k can be 2.0 (i.e. 2/1), 1.5 (i.e. 3/2), 1.25 (i.e. 5/4) etc.

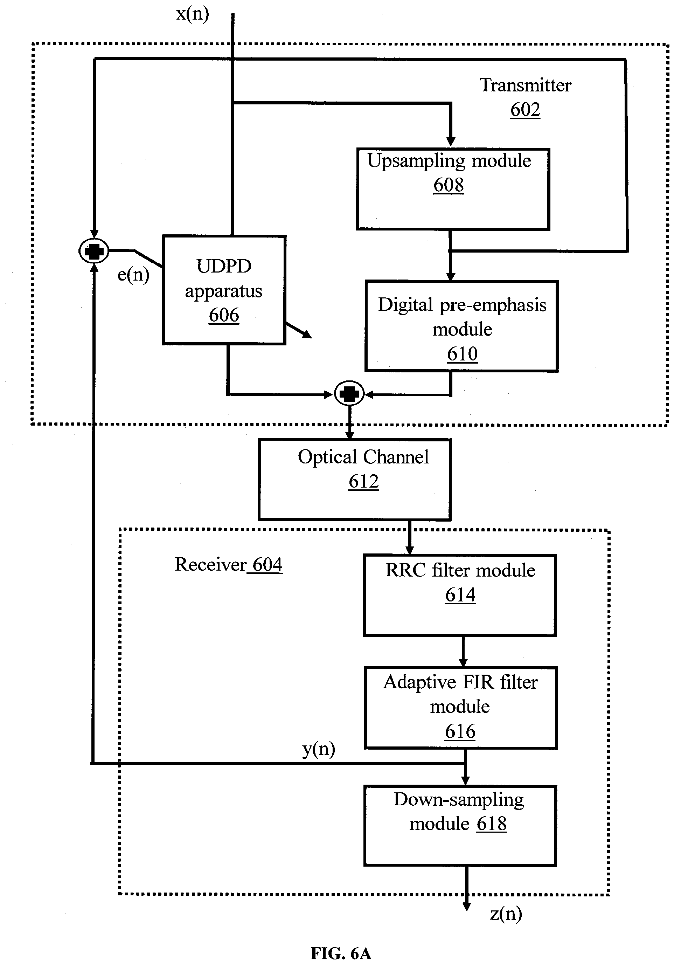

The feedback feeder **112** can be configured for receiving an upsampled input signal having the second sampling rate from an upsampling unit, and a feedback signal sampled at the second sampling rate from a receiver chain, and summing up the upsampled input signal with the inverted feedback signal to obtain the error signal sampled at the second sampling rate. An exemplary diagram of a communication system with the UDPD apparatus implementing such an upsampled feedback scheme is shown in FIG.6A. In this case the feedback feeder 112 and the feedback decomposer **114** operate with signals sampled at the second sampling rate, i.e. a high SPS sampling rate.

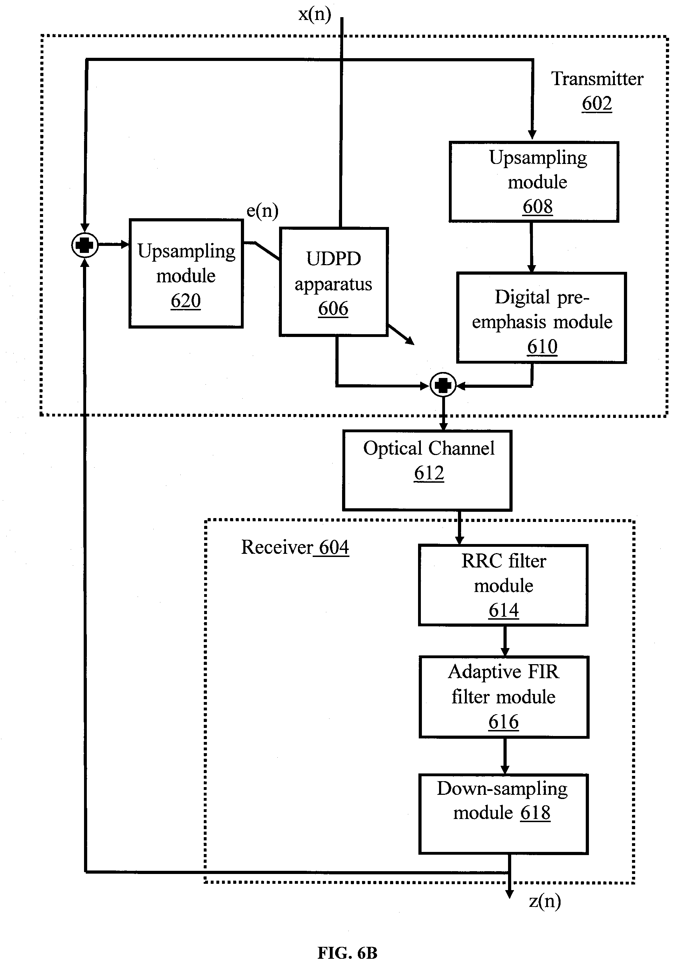

Alternatively, the feedback feeder **112** can receive the input signal having the first sampling rate from the feeder **102** and a feedback signal sampled at the first sampling rate from a receiver chain. In this case the feedback feeder 112 is configured for summing up the input signal with the inverted feedback signal, each having the first sampling rate, to obtain the error signal having the first sampling rate, and for upsampling the error signal to the second sampling rate to obtain the error signal sampled at the second sampling rate. An exemplary diagram of a communication system with the UDPD apparatus implementing such a non-upsampled feedback scheme is shown in FIG.6B.

The predistortion unit **108** can be configured for generating each predistortion signal subset by summing up the k_down model input signal subsets multiplied each by an adaptation coefficient. Thereby, k_down adaptation coefficients are used for generating each predistortion signal subset, and k_up*k_down adaptation coefficients are to be calculated for generating k_up predistortion signal subsets.

Optionally, the predistortion unit **108** can be configured for determining, for each predistortion signal subset, the biggest adaptation coefficient among k down adaptation coefficients of the k_down model input signal subsets to be combined for generating the given predistortion signal subset. In this case the predistortion unit **108** is further configured for selecting a model input signal subset with the biggest adaptation coefficient as an only term that contributes to the given predistortion signal subset. The rest of the k_down adaptation coefficients, except for the biggest one, can be discarded which allows reducing the complexity significantly with a minor impact in the performance.

The evaluator **106** can be configured for applying a non-linear spline model. Furthermore, the evaluator **106** can be configured for calculating spline functions of the non-linear spline model using lookup tables. The use of the non-linear spline model enables the apparatus **100** to significantly reduce the complexity in the transmitter and improve the system performance.

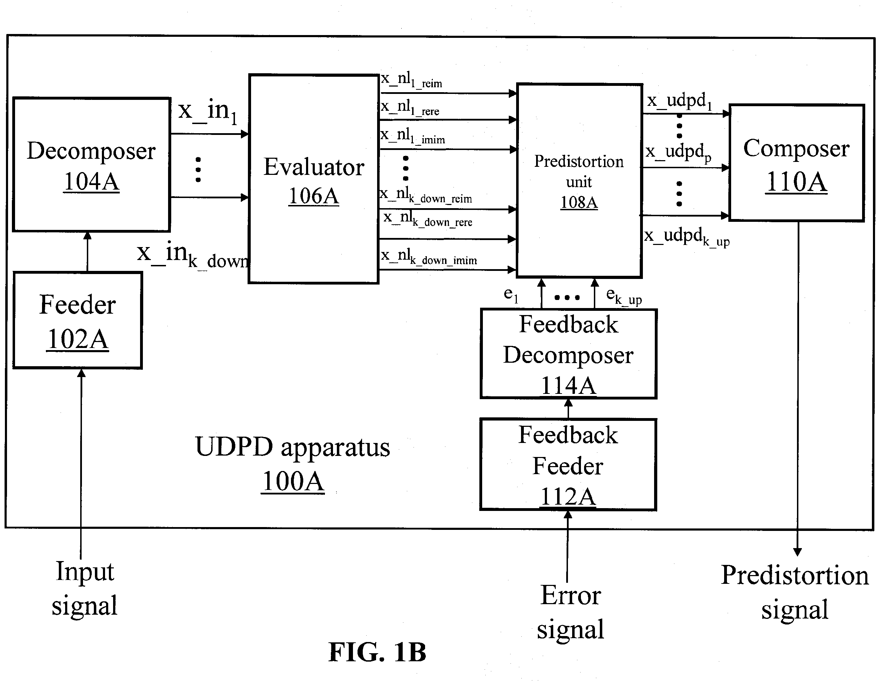

FIG. 1B is a block diagram of an apparatus **100A** for predistortion of a digital signal in a transmitter chain which can be referred to as a UDPD apparatus **100A**. The UDPD apparatus **100A** comprises a feeder **102A,** a decomposer **104A,** an evaluator **106A,** a predistortion unit **108A** and a composer **110A.** The feeder **102A** is configured for obtaining an input signal of a length N sampled at a first sampling rate. The decomposer **104A** is configured for decomposing the input signal into k_down input signal subsets of equal length L by sequentially assigning each k_down-th sample of the input signal, starting with an I-th sample, to an I-th input signal subset in ascending order of sample number, where L, k down and I are integers, I being from 1 to k_down.

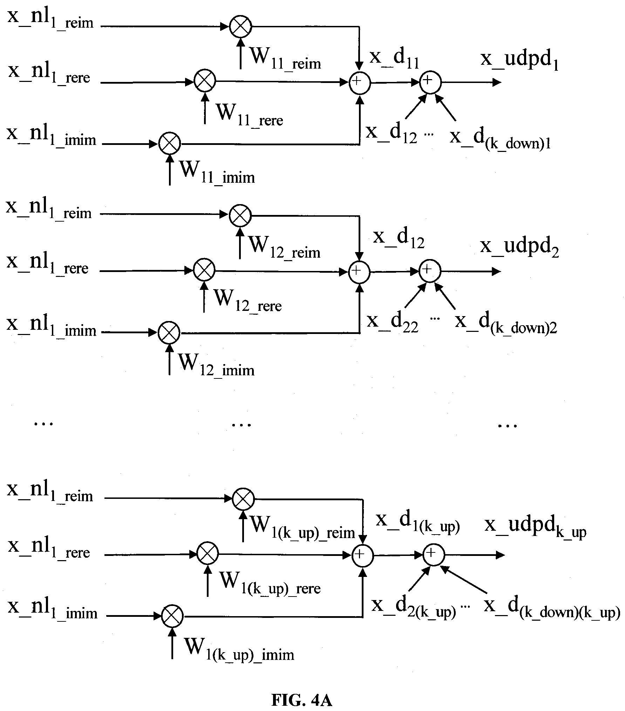

The evaluator **106A,** in contrast to the evaluator **106** of FIG. 1A, is configured for generating k_down groups of 3 model input signal subsets (x_nl_reim, x_nl_rere and x_nl_imim) of equal length L, by applying a non-linear model to every input signal subset to generate a group of 3 model input signal subsets from every input signal subset. Each group comprises (i) a product of an input signal subset shifted by a first index and two spline functions of a real part of the input signal subset shifted by a second index and of an imaginary part of the input signal subset shifted by a third index (x_nl_reim), (ii) a product of the input signal subset shifted by the first index and two spline functions of two real parts of the input signal subset shifted by the second index and by the third index (x_nl_rere), and, (iii) a product of the input signal subset shifted by the first index and two spline functions of two imaginary parts of the input signal subset shifted by the second index and by the third index (x_nl_imim). The predistortion unit **108A** is configured for generating k_up predistortion signal subsets of equal length L. Each predistortion signal subset is generated by combining the k_down groups of 3 model input signal subsets, wherein each model input signal subset is multiplied by an adaptation coefficient, as illustrated in FIG.4A. K_up is an integer greater than k_down. The composer **110A** is configured for generating a predistortion signal with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned as illustrated in FIG. 5. The first sampling rate can be 1 SPS.

The UDPD apparatus **100A** provides for all the effects and benefits of the UDPD apparatus **100** described above with reference to FIG. 1A and it additionally features the use of spline functions as the non-linear model for generating the input signal subsets which allows further reducing the complexity of the transmitter and improving the performance. At that, the UDPD apparatus **100A** can be based on relatively low-cost hardware for generating nonlinear distortions.

The apparatus **100A** further comprises a feedback feeder **112A** and a feedback decomposer **114A**. The feedback feeder **112A** is configured for obtaining an error signal of a length k*N sampled at the second sampling rate. The feedback decomposer **114A** is configured for decompressing the error signal into k_up error signal subsets of equal length L by sequential assigning each k up-th sample of the error signal, starting with an p-th sample, to an p-th error signal subset in ascending order of sample number, p being from 1 to k_up, as illustrated in FIG. 3A. The predistortion unit **108A** is further configured for calculating k_up*k_down groups of 3 adaptation coefficients for the k_down model input signal subsets on the basis of the k_up error signal subsets.

The feedback feeder **112A** can be configured for receiving an upsampled input signal having the second sampling rate from an upsampling unit, and a feedback signal sampled at the second sampling rate from a receiver chain, and for summing up the upsampled input signal with the inverted feedback signal to obtain the error signal sampled at the second sampling rate. An exemplary diagram of a communication system with the UDPD apparatus implementing such an upsampled feedback scheme is shown in FIG.6A.

Alternatively, the feedback feeder **112A** can be configured for receiving the input signal having the first sampling rate from the feeder **102A** and a feedback signal sampled at the first sampling rate from a receiver chain, summing up the input signal with the inverted feedback signal, each having the first sampling rate, to obtain the error signal having the first sampling rate, and for upsampling the error signal to the second sampling rate to obtain the error signal sampled at the second sampling rate. An exemplary diagram of a communication system with the UDPD apparatus implementing such a non-upsampled feedback scheme is shown in FIG.6B.

The predistortion unit **108A** can be configured for generating each predistortion signal subset by summing up the k_down groups of 3 model input signal subsets ($x\_nl_{reim}$, $x\_nl_{rere}$ and $x\_nl_{imim}$) multiplied each by an adaptation coefficient ($W_{reim}$, $W_{rere}$, $W_{imim}$), as illustrated in FIG. 4A.

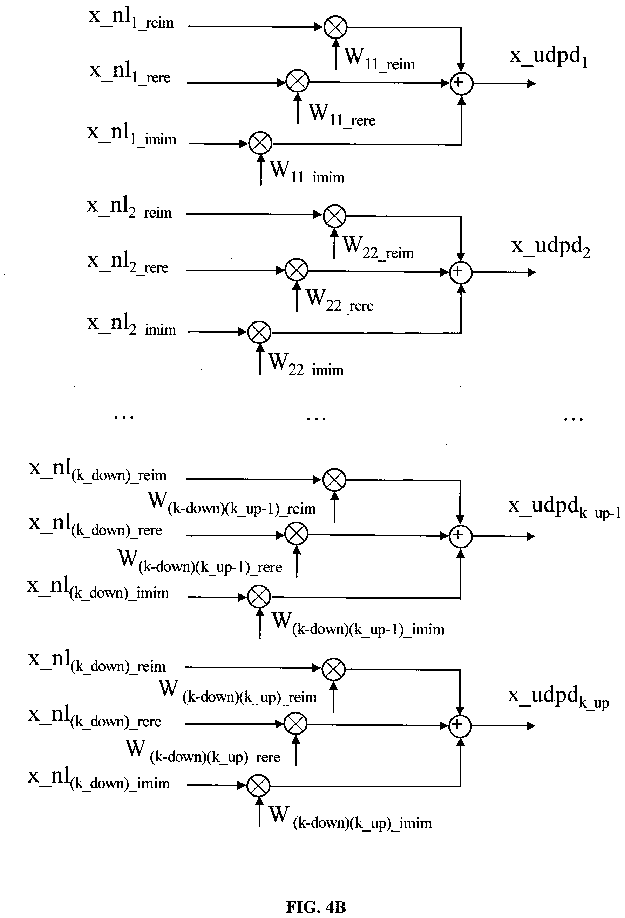

Optionally, the predistortion unit **108A** can be configured for determining, for each predistortion signal subset, a group of 3 adaptation coefficients ($W_{reim}$, $W_{rere}$, $W_{imim}$) having the biggest values among k_down groups of 3 adaptation coefficients of the k_down groups of 3 model input signal subsets to be combined for generating the given predistortion signal subset. In this case the predistortion unit **108A** is configured for selecting a group of 3 model input signal subsets with the adaptation coefficients of the biggest values as an only term that contributes to the given predistortion signal subset, as illustrated in FIG. 4B. The evaluator **106A** is configured for calculating spline functions of the non-linear spline model using lookup tables.

FIGS. 2A and 2B illustrate decomposing an input signal into subsets or phases in accordance with implementations of the disclosure, for example, by the decomposer **104, 104A**. FIG. 2A relates to a generic case where the input signal **202** of a length N is decomposed into k_down subsets **204A, 204B, 204C** of equal length L. FIG. 2B relates to a special case where k_down equals 2, and the input signal **202A** is decompressed into 2 subsets **204D** and **204E**. As shown, the input signal is decomposed into k down input signal subsets by sequentially assigning each k_down-th sample of the input signal starting with an l-th sample, to an l-th input signal subset in ascending order of sample number, where L, k down, and I are integers, I being from 1 to k_down.

FIGS. 3A and 3B illustrate decomposing an error signal into subsets or phases in accordance with implementations of the disclosure, for example, by the feedback decomposer **114, 114A**. An error signal **302** of a length k*N is sampled at a second sampling rate, wherein k is the predistortion upsampling factor defined as a ratio k_up/k_down. FIG. 3A relates to a generic case where the error signal **302** is decomposed into k_up subsets **(304A, 304B)** of equal length L. As shown, the error signal **302** includes k*N samples that are divided into k_up error signal subsets of equal length L by sequential assigning each k up-th sample of the error signal **302,** starting with an p-th sample, to an p-th error signal subset **(304A, 304B)** in ascending order of sample number, p being from 1 to k_up. FIG. 2B relates to a special case where k_up equals 3, and the input signal **302A** is decompressed into 3 subsets **304C, 304D** and **304E.**

In accordance with the disclosure, k_down input signal subsets of equal length L, obtained in result of the decomposing of the input signal as described above with reference to FIGS.2A and 2B, are subject to applying a non-liner model for generating model input signal subsets of equal length L, for example, by the evaluator **106** or **106A.**

The evaluator **106** is configured for generating k_down model input signal subsets of equal length L, by applying a non-linear model to each of the k down input signal subsets. The evaluator **106A** is configured for generating k_down groups of 3 model input signal subsets of equal length L, by applying a non-linear model to every input signal subset to generate a group of 3 model input signal subsets from each input signal subset.

In the content of the preset disclosure, the non-linear model can be any memory model. However, a better performance of the system in terms of complexity can be achieved by using a non-linear spline model. Splines are polynomial curves for interpolation or approximation of a sequence of Q+1 points or knots $Q_i$. Each knot $Q_i$ can be presented by a real part of the input signal and an imaginary part of the input signal:

$$Q_i = [q_{x_{re},i}, q_{x_{im},i}]^T,$$

where i = 0, 1, ..., Q.

The sequence of the knots is defined so as

$$q_{x,0} < q_{x,1} < \cdots < q_{x,Q},$$

where $q_{x,0}$ is a minimum value of the input signal, $q_{x,Q}$ is a maximum value of the input signal. That is, a range of the input signal is divided into Q subintervals.

Spline function of degree 1 is defined as follows:

$$SPL_i^1(x) = \begin{cases} \dfrac{x - q_{x,i}}{q_{x,i+1} - q_{x,i}}, & q_{x,i} \le x < q_{x,i+1}, \\ \dfrac{q_{x,i+2} - x}{q_{x,i+2} - q_{x,i+1}}, & q_{x,i+1} \le x < q_{x,i+2}, \\ 0, & \text{otherwise.} \end{cases}$$

Each input signal subset can be presented by a group of 3 model subsets as shown in FIG. 1B:

$$x_{nl_{l\text{reim}}}(n, j_1, j_2, j_3, i_1, i_2) = x_{in_l}(n - j_1) \cdot SPL_{i_1}(x_{in_{l\text{real}}}(n - j_3)) \cdot SPL_{i_2}(x_{in_{l\text{imag}}}(n - j_2)),$$

$$x_{nl_{l\text{rere}}}(n, j_1, j_2, j_3, i_1, i_2) = x_{in_l}(n - j_1) \cdot SPL_{i_1}(x_{in_{l\text{real}}}(n - j_3)) \cdot SPL_{i_2}(x_{in_{l\text{real}}}(n - j_2)),$$

$$x_{nl_{l\text{imim}}}(n, j_1, j_2, j_3, i_1, i_2) = x_{in_l}(n - j_1) \cdot SPL_{i_1}(x_{in_{l\text{imag}}}(n - j_3)) \cdot SPL_{i_2}(x_{in_{l\text{imag}}}(n - j_2)),$$

where $x_{in_l}(n - j_1)$ is an *l*-th input signal subset shifted by a first index $j_1$, *l* being from 1 to *k_down*, $SPL_{i_1}(x_{in_{l\text{real}}}(n - j_3))$ ) is the spline function as defined above of a real part of the *l*-th input signal subset shifted by a second index $j_3$,

$SPL_{i_2}(x_{in_{l\text{imag}}}(n - j_2))$ ) is the spline function of an imaginary part of the input signal subset shifted by a third index $j_2$,

$i_1, j_2 j_3$ are shift indexes, and $i_1, i_2$ are knot indexes of the spline function.

In case the input signal is sampled at 1 SPS sampling rate, each sample of the input signal can be interpolated by a spline function with a single knot, equals to 1, which means that the model input signal subsets can be generated using lookup tables, LUT, for calculating the spline functions. This can significantly reduce the complexity of calculations and improve the performance. In this case, each input signal subset can be presented by a group of 3 model input signal subsets:

$$x_{nl_{l\text{reim}}}(n, j_1, j_2, j_3, i_1, i_2) = x_{in_l}(n - j_1) \cdot LUT_{\text{reim}}(j_2, j_3, i_1, i_2),$$

$$x_{nl_{l\text{rere}}}(n, j_1, j_2, j_3, i_1, i_2) = x_{in_l}(n - j_1) \cdot LUT_{\text{re}}(j_2, j_3, i_1, i_2),$$

$$\mathbf{x}_{\mathbf{nl}_{l_{imim}}}(n, j_1, j_2, j_3, i_1, i_2) = \mathbf{x}_{\mathbf{in}_l}(n - j_1) \cdot \mathrm{LUT}_{im}(j_2, j_3, i_1, i_2),$$

where

$$\mathrm{LUT}_{reim}(j_2, j_3, i_1, i_2) = \mathrm{SPL}_{i_1}(\mathbf{x}_{\mathbf{in}_{l_{real}}}(n - j_3)) \cdot \mathrm{SPL}_{i_2}(\mathbf{x}_{\mathbf{in}_{l_{imag}}}(n - j_2)),$$

$$\mathrm{LUT}_{re}(j_2, j_3, i_1, i_2) = \mathrm{SPL}_{i_1}(\mathbf{x}_{\mathbf{in}_{l_{real}}}(n - j_3)) \cdot \mathrm{SPL}_{i_2}(\mathbf{x}_{\mathbf{in}_{l_{real}}}(n - j_2)),$$

and

$$\mathrm{LUT}_{im}(j_2, j_3, i_1, i_2) = \mathrm{SPL}_{i_1}(\mathbf{x}_{\mathbf{in}_{l_{imag}}}(n - j_3)) \cdot \mathrm{SPL}_{i_2}(\mathbf{x}_{\mathbf{in}_{l_{imag}}}(n - j_2)),$$

$l$ being from 1 to k_down.

The above formulas represent k down groups of 3 model input signal subsets of equal length L that are generated by the evaluator **106A** and provided to the predistortion unit **108A** as illustrated in FIG. 1B. The predistortion unit **108A** is configured for generating k_up predistortion signal subsets of equal length L based on the k_down groups of 3 model input signal subsets. Each predistortion signal subset is generated by combining the k down groups of 3 model input signal subsets multiplied each by an adaptation coefficient. Thus, 3*k_down adaptation coefficients are to be used for generating each predistortion signal subsets, and k_up*3_*k down adaptation coefficients are to be used for generating all the k_up predistortion signal subsets.

The predistortion unit **108A** can be also provided with k_up error signal subsets of equal length L from the feedback decomposer **114A.** The error signal subsets can be used for updating the predistortion algorithm by updating the adaptation coefficients applied by the predistortion unit **108A** to the model input signal subsets. For this end, the predistortion unit **108A** is configured for calculating k_up*k_down groups of 3 adaptation coefficients for the k_down groups of 3 model input signal subsets on the basis of the k_up error signal subsets.

In an embodiment, the predistortion algorithm update comprises calculating the adaptation coefficients for each model input signal subset by a least squares (LS) method. The method of least squares is based on a criterion according to which an estimation of parameters is optimal if a sum of error squares is minimal. Thus, the LS criterion is defined as follows:

$$S = \sum_{n=0}^{N-1} \mathrm{err}^2(n),$$

where err(n) = d(n) - y(n), an error between a desired signal d(n) and an output signal y(n).

Adaptation coefficients can be obtained by solving in the LS sense an overdetermined linear system $V_l \cdot W_{lp}$ = $err_p$. The LS estimate is given by

$$\mathbf{W_{lp}} = \mu \cdot (\mathbf{V}_l^* \mathbf{V}_l + \mathbf{reg})^{-1} \mathbf{V}_l^* \mathbf{err_p} + \lambda \cdot \mathbf{W}_{lp_{old}},$$

where $(V_l^* V_l)^{-1} V_l^*$ is known as a pseudo-inverse of $V_l$, $V_l$ is an $l$-th model input signal subset, $l$ being from 1 to k down, $p$ being from 1 to k_up, $W_{lp\mathrm{old}}$ are former adaptation coefficients applied for generating the predistortion signal subsets on previous iteration (i.e. the coefficients used before the current predistortion algorithm update), $\mu$ is a weight of new coefficients, $\mu$ = (0,1], $\lambda$ is a "memory" of former coefficients, $\lambda$ = (0,1], reg = $\alpha \cdot E \cdot (\mathrm{err}^* \cdot \mathrm{err}) \cdot \frac{1}{N} \cdot \sum_{j=0}^{N-1} (V_l^* V_l)_{jj}$ is a regularization function matrix, where E is unit matrix, and $\alpha$ is a regularization parameter.

In case of generating the k_down groups of 3 model input signal subsets ( $x_{\mathrm{nl}_{l_{reim}}}, x_{\mathrm{nl}_{l_{rere}}}, x_{\mathrm{nl}_{l_{imim}}}$ ) as defined above, the adaptation coefficients can be calculated as follows:

$$\mathbf{W}_{lp_{reim}} = \mu \cdot (\mathbf{V}_{l_{reim}}^* \mathbf{V}_{l_{reim}} + \mathbf{reg})^{-1} \mathbf{V}_{l_{reim}}^* \mathbf{err_p} + \lambda \cdot \mathbf{W}_{lp_{reim_{old}}},$$

$$\mathbf{W}_{lp_{rere}} = \mu \cdot (\mathbf{V}_{l_{rere}}^* \mathbf{V}_{l_{rere}} + \mathbf{reg})^{-1} \mathbf{V}_{l_{rere}}^* \mathbf{err_p} + \lambda \cdot \mathbf{W}_{lp_{rere_{old}}},$$

$$\mathbf{W}_{lp_{imim}} = \mu \cdot (\mathbf{V}_{l_{imim}}^* \mathbf{V}_{l_{imim}} + \mathbf{reg})^{-1} \mathbf{V}_{l_{imim}}^* \mathbf{err_p} + \lambda \cdot \mathbf{W}_{lp\_imim_{old}}.$$

Depending on the nonlinearity of the system, that is, on a gain and on a variance of the error, it is necessary to change the regularization parameter as follows:

$$\alpha = \frac{1}{\sqrt{10^{0.1 \cdot G}} \cdot 8e3 \cdot \text{var(err)}}$$

where var(err) is the variance of the error, G is the gain parameter of a power amplifier in decibels, dB.

FIG. 4A illustrates the generating of the k_up predistortion signal subsets x_udpd$_p$, p being from 1 to k_up, in accordance with an implementation of the disclosure, using the adaptation coefficients $W_{lpreim}$, $W_{lprere}$, $W_{lpimim}$ that can be calculated by the above formulas.

In FIG. 4A, there is a summing of k down terms for generating each predistortion signal subset, wherein each one of the k down terms is a corresponding model input signal subset multiplied by a corresponding adaptation coefficient:

$$x_{udpd_1} = x_{d_{11}} + x_{d_{21}} + \cdots + x_{d_{k_{down1}}} = [V_{1_{reim}} \cdot W_{11_{reim}} + V_{1_{rere}} \cdot W_{11_{rere}} + V_{1_{reim}} \cdot W_{11_{imim}}] + [V_{2_{reim}} \cdot$$

$$W_{21_{reim}} + V_{2_{rere}} \cdot W_{21_{rere}} + V_{2_{reim}} \cdot W_{21_{imim}}] + \cdots + [V_{k_{down_{reim}}} \cdot W_{k_{down}1_{reim}} + V_{k_{down_{rere}}} \cdot W_{k_{down}1_{rere}} +$$

$$V_{k_{down_{reim}}} \cdot W_{k_{down}1_{imim}}],$$

$$\cdots$$

$$x_{udpd_{k_{up}}} = x_{d_{1k_{up}}} + x_{d_{2k_{up}}} + \cdots + x_{d_{k_{down}k_{up}}} = [V_{1_{reim}} \cdot W_{1k_{up_{reim}}} + V_{1_{rere}} \cdot W_{1k_{up_{rere}}} + V_{1_{reim}} \cdot W_{1k_{up_{imim}}}] +$$

$$\left[V_{2_{reim}} \cdot W_{2k_{up_{reim}}} + V_{2_{rere}} \cdot W_{2k_{up_{rere}}} + V_{2_{reim}} \cdot W_{2k_{up_{imim}}}\right] + \cdots + [V_{k_{down_{reim}}} \cdot W_{k_{down}k_{up_{reim}}} + V_{k_{down_{rere}}} \cdot$$

$$W_{k_{down}k_{up_{rere}}} + V_{k_{down_{reim}}} \cdot W_{k_{down}k_{up_{imim}}}],$$

FIG. 4B illustrates an optional optimization of the predistortion algorithm for reducing the computational complexity. The fact is that some terms to be summed for generating each predistortion signal subset can have small adaptation coefficients. For the optimization, the biggest adaptation coefficient, or a group of 3 adaptation coefficients having the biggest values, can be determined for each predistortion signal subset. Then, a model input signal subset with the biggest adaptation coefficient, or a group of 3 model input signal subsets with the adaptation coefficients of the biggest values, can be selected as an only term that contributes to the given predistortion signal subset. All the rest terms can be discarded. Experience has shown that the optimization as described allows significantly reducing the complexity of the predistortion processing at the expense of minor impact in the overall performance of the communication system.

FIG. 5 illustrates merging the predistortion signal subsets **502, 504** and **506** into a predistortion signal **508** in accordance with an implementation of the disclosure. The predistortion signal **508** has a second sampling rate which is k_up/k_down times a first sampling rate, k_up is an integer greater than k_down. As shown in FIG.5, the merging of the k_up predistortion signal subsets 502, **504, 506** comprises sequentially assigning one sample from each predistortion signal subset, in ascending order of subset number, from 1 to k_up, to the predistortion signal until all samples of the k_up predistortion signal subsets are assigned.

FIGS. 6A and 6B are block diagrams of exemplary communication systems with an apparatus for predistortion of a digital signal, which can be referred to a UDPD apparatus, in a transmitter chain in accordance with implementations of the disclosure that differ from each other by a feedback scheme. Each of the communication systems in FIGS. 6A and 6B comprises a transmitter **602** and a receiver **604** in communication with each other through an optical channel **612**. The transmitter **602** comprises the apparatus for predistortion of a digital signal or the UDPD apparatus **606,** an upsampling module **608,** and a digital pre-emphasis module **610**. The receiver **604** comprises a root raised cosine, RCC, filter module **614,** an adaptive finite impulse response, FIR, filter module **616,** and a downsampling module **618**. The UDPD apparatus **606** is provided with an input signal sampled at a first, low SPS, sampling rate and an error signal sampled at a second, high SPS, sampling rate to generate a predistortion signal having the second, high SPS, sampling rate. In FIG. 6A the error signal sampled at the second, high SPS, sampling rate is provided to the UDPD apparatus from the receiver chain. FIG. 6B illustrates another implementation of the communication system where the error signal from the receiver chain is sampled at the first, low SPS, sampling rate. In this case, the error signal is subject to upsampling, by an upsampling module **620,** to the second, high SPS, sampling rate before feeding to the UDPD apparatus **606.**

As described above, the UDPD apparatus **606** has a polyphase structure, where the input and error signals are decomposed into a plurality of subsets or phases which are processed separately, that provides for an improved performance of the system while maintaining the complexity low. The UDPD apparatus **606** allows conducting the upsampling and the pre-emphasis processing in parallel with the predistortion processing which allows reducing the complexity of these processes as well as the overall complexity of the digital processing in the system.

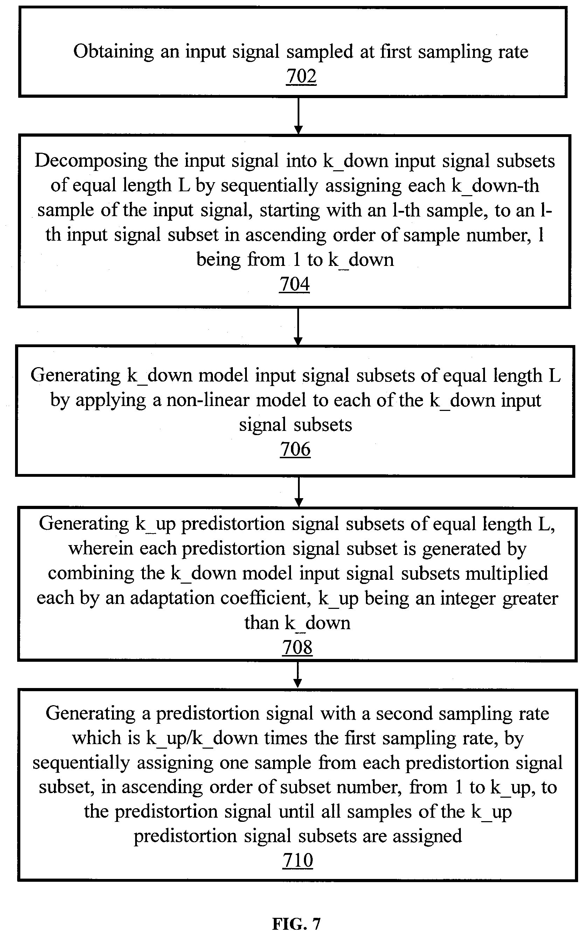

FIG. 7 is a flow diagram of a method of predistortion of a digital signal in a transmitter chain, which can be referred to as a UDPD method, in accordance with an implementation of the disclosure. At a step **702** of the UDPD method, an input signal sampled at a first sampling rate is obtained. At a step **704,** the input signal is decomposed into k_down input signal subsets or phases of equal length L by sequentially assigning each k_down-th sample of the input signal, starting with an l-th sample, to an l-th input signal subset in ascending order of sample number where L, k_down and l are integers, l being from 1 to k_down. At a step **706,** k_down model input signal subsets of equal length L are generated, by applying a non-linear model to each of the k_down input signal subsets. At a step **708,** k_up predistortion signal subsets of equal length L are generated. Each predistortion signal subset is generated by combining the k_down model input signal subsets multiplied each by an adaptation coefficient, where k_up is an integer greater than k_down. At a step **710,** a predistortion signal is generated with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned.

The UDPD method as described above has the polyphase structure that provides for embedding an upsampling into the predistortion process and thereby allows increasing the performance of the digital signal processing while maintaining the complexity low. The method can be implemented with different upsampling factors within the predistortion processing. Therefore, the use of the method as described allows reducing a penalty introduced to a communication system by non-liner characteristics of components such as power amplifiers, PA, and in-phase and quadrature modulator, IQM, in an optimized and effective manner.

The UDPD method can further comprise (i) obtaining an error signal sampled at the second sampling rate, (ii) decompressing the error signal into k_up error signal subsets or phases of equal length L by sequential assigning each k _up-th sample of the error signal, starting with an p-th sample, to an p-th error signal subset in ascending order of sample number, p being from 1 to k_up, and (iii) calculating k_up*k_down adaptation coefficients for the k_down model input signal subsets on the basis of the k_up error signal subset.

At that, each predistortion signal subset can be generated by summing up the k_down model input signal subsets multiplied each by an adaptation coefficient.

Optionally, the UDPD method can comprises determining, for each predistortion signal subset, the biggest adaptation coefficient among k_down adaptation coefficients of the k_down model input signal subsets to be combined for generating the given predistortion signal subset, and selecting a model input signal subset with the biggest adaptation coefficient as an only term that contributes to the given predistortion signal subset.

The first, low sampling rate can be of 1 SPS. The non-liner model can be a non-linear spline model, and the applying of the non-linear spline model can comprise calculating spline functions using lookup tables.

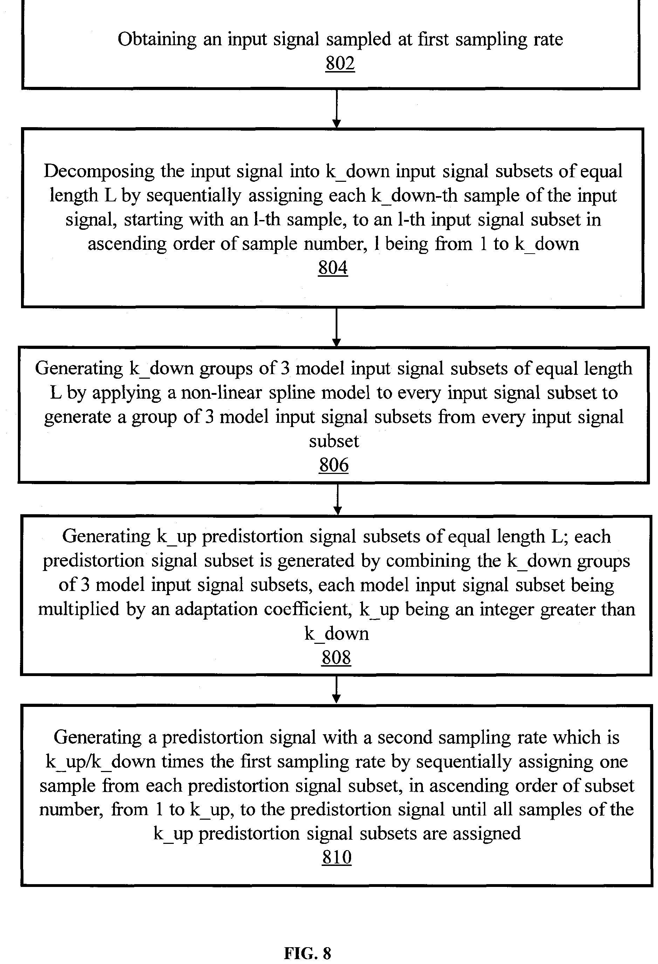

FIG. 8 is flow diagram of a method of predistortion of a digital signal in a transmitter chain, which can be referred to as a UDPD method, in accordance with another implementation of the disclosure, where a group of 3 model input signal subsets is generated from every input signal subset by applying to it a non-linear spline model. Namely, at a step **802,** an input signal sampled at a first sampling rate is obtained. At a step **804,** the input signal is decomposed into k_down input signal subsets or phases of equal length L by sequentially assigning each k_down-th sample of the input signal, starting with an l-th sample, to an l-th input signal subset in ascending order of sample number where L, k_down and l are integers, l being from 1 to k_down. At a step **806,** k_down groups of 3 model input signal subsets of equal length L are generated by applying a non-linear spline model to every input signal subset to generate a group of 3 model input signal subsets from every input signal subset. Each group comprises (i) a product of an input signal subset shifted by a first index and two spline functions of a real part of the input signal subset shifted by a second index and of an imaginary part of the input signal subset shifted by a third index, (ii) a product of the input signal subset shifted by the first index and two spline functions of two real parts of the input signal subset shifted by the second index and by the third index, and (iii) a product of the input signal subset shifted by the first index and two spline functions of two imaginary parts of the input signal subset shifted by the second index and by the third index. At a step **808,** k_up predistortion signal subsets of equal length L are generated. Each predistortion signal subset is generated by combining the k down groups of 3 model input signal subsets, where each model input signal subset is multiplied by an adaptation coefficient, and k_up is an integer greater than k_down. At a step **810,** a predistortion signal is generated with a second sampling rate which is k_up/k_down times the first sampling rate, by merging the k_up predistortion signal subsets. The merging of the k_up predistortion signal subsets comprises sequentially assigning one sample from each predistortion signal subset, in ascending order of subset number, from 1 to k_up, to the predistortion signal until all samples of the k_up predistortion signal subsets are assigned.

This implementation of the UDPD method provides for all the effects and advantages of the UDPD method described with reference to FIG. 7 and allows further decreasing the complexity due to the use of the spline model and possible use of lookup tables to calculate the spline functions.

The UDPD method can further comprise (i) obtaining an error signal sampled at the second sampling rate, (ii) decompressing the error signal into k_up error signal subsets or phases of equal length L by sequential assigning each k_up-th sample of the error signal, starting with an p-th sample, to an p-th error signal subset in ascending order of sample number, p being from 1 to k_up, and (iii) calculating k_up*k_down groups of 3 adaptation coefficients for the 3 model input signal subsets on the basis of the k_up error signal subset.

At that, each predistortion signal subset can be generated by summing up the k_down groups of 3 model input signal subsets, where each model input signal subset is multiplied by an adaptation coefficient.

Optionally, the UDPD method can comprises (i) determining, for each predistortion signal subset, a group of 3 adaptation coefficients having the biggest values among k_down groups of 3 adaptation coefficients of the k_down groups of 3 model input signal subsets to be combined for generating the given predistortion signal subset, and, (ii) selecting a group of 3 model input signal subsets with the adaptation coefficients of the biggest values as an only term that contributes to the given predistortion signal subset.

The first sampling rate can be 1 SPS, and the applying of the non-linear spline model can comprises calculating the spline functions using lookup tables.

The complexity of the UDPD processing in the methods and apparatuses of the present disclosure can be calculated, for example, by cost table of 7 nm process metal-oxide-semiconductor field-effect transistors, MOSFETs, of Taiwan Semiconductor Manufacturing Company, TSMC, depending on the number of required multiplications and additions for different bit depths of the input signal and the adaptation coefficients.

In case of using the non-linear spline model and calculating the spline functions with the lookup tables as described above, the whole UDPD processing to obtain an p-th output predistortion signal subset or phase can be defined as follows:

$$x_{udpd_p}(n) = \sum_{l=0}^{k_{down}-1} \sum_{j_1=0}^{M-1} x_{in_l}(n-j_1)$$

$$\cdot \sum_{j_2=0}^{M-1} \sum_{j_3=0}^{M-1} \sum_{i_1=0}^{Q-1} \sum_{i_2=0}^{Q-1} \left[ W_{lp_{re_{j_1 j_2 j_3 i_1 i_2}}} \cdot LUT_{l_{re}}(j_2 j_3 i_1 i_2) + W_{lp_{im_{j_1 j_2 j_3 i_1 i_2}}} \cdot LUT_{l_{im}}(j_2 j_3 i_1 i_2) \right.$$

$$\left. + W_{lp_{reim_{j_1 j_2 j_3 i_1 i_2}}} \cdot LUT_{l_{reim}}(j_2 j_3 i_1 i_2) \right] \right]$$

where

$$LUT_{l_{re}}(j_2 j_3 i_1 i_2) = SPL_{i_1}\left(x_{in_{l_{real}}}(n-j_2)\right) \cdot SPL_{i_2}\left(x_{in_{l_{real}}}(n-j_3)\right),$$

$$LUT_{l_{im}}(j_2 j_3 i_1 i_2) = SPL_{i_1}\left(x_{in_{l_{imag}}}(n-j_2)\right) \cdot SPL_{i_2}\left(x_{in_{l_{imag}}}(n-j_3)\right),$$

and

$$LUT_{l_{reim}}(j_2 j_3 i_1 i_2) = SPL_{i_1}\left(x_{in_{l_{real}}}(n-j_2)\right) \cdot SPL_{i_2}\left(x_{in_{l_{imag}}}(n-j_3)\right).$$

It can be seen that the UDPD processing as written above comprises 2 additions of the adaptation coefficients

$$\left[ W_{lp_{re_{j_1 j_2 j_3 i_1 i_2}}} + W_{lp_{im_{j_1 j_2 j_3 i_1 i_2}}} + W_{lp_{reim_{j_1 j_2 j_3 i_1 i_2}}} \right]$$

, 2*(M-1) additions of the adaptation coefficients due to a memory parameter of M, M multiplications of the input signal samples and the adaptation coefficients $[x_{in_l}(n - j_3) \cdot W]$, M-1 additions of results of said multiplications and $k_{down}$ - 1 additions of the terms.

In case the input signal is a 16-quadrature amplitude modulation, QAM, signal with 1 SPS sampling rate, the bit depth of the input signal samples can be set to 2 bits. The predistortion signal is an upsampled signal having k SPS sampling rate in accordance with the disclosure, thereby it requires a minimum of 6 bits, depending on the adaptation coefficients bit depth. The adaptation coefficients bit depth can be set in a range of 4 bits to 10 bits, depending on a required performance of the system.

For example, for $k = \frac{k\_up}{k\_down} = \frac{3}{2}$, 2 bits of the input signal, 8 bits of the adaptation coefficients, 8 bits of the output predistortion signal, and M = 2 of the memory parameter, the overall complexity of the UDPD processing to obtain an output predistortion signal subset of length $L = N/k\_down$ can be calculated as follows:

$$C_{UDPD1} = ((k\_down - 1) \cdot 41 + k\_down \cdot [M \cdot (80 + (M \cdot M - 1) \cdot 41 + M \cdot M \cdot 82) + (M - 1) \cdot 41]) \cdot \frac{N}{k\_down}$$

$$= 3540.5 \cdot N \ gates$$

Thereby, the complexity of the UDPD processing to obtain all the k_up predistortion signal subsets is:

$$C_{UDPD} = C_{UDPD1} \cdot k\_up = 10621 \cdot N \ gates.$$

The overall complexity of the optimized UDPD processing can be calculated as follows:

$$C_{UDPD1_{opt}} = (M \cdot (80 + (M \cdot M - 1) \cdot 41 + M \cdot M \cdot 82) + (M - 1) \cdot 41) \cdot \frac{N}{k\_down} =$$

$$= 1760 \cdot N \ gates,$$

$$C_{UDPDopt} = C_{UDPD1_{opt}} \cdot k\_up = 5280 \cdot N \ gates.$$

The computational complexity of the proposed UDPD method and apparatus as calculated above can be compared with the complexity of the known DPD methods of two types mentioned in the Background section.

The complexity of the known DPD method of the first type (hereinafter - DPD-1) that operates on 1 SPS input and error signals of length N and uses the same functions and parameters as set above for the UDPD method complexity estimate can be calculated as follows:

$$C_{DPD_1} = ((M - 1) \cdot 41 + M \cdot [80 + (M \cdot M - 1) \cdot 41 + M \cdot M \cdot 82]) \cdot N = 3520 \cdot N \ gates$$

The complexity of the known DPD method of the second type (hereinafter - DPD-2) that operates on upsampled to k SPS input and error signals of length N and uses the same functions and parameters as set above for the UDPD method complexity estimate can be calculated as follows:

$$C_{DPD_2} = (((166 + 41) * 2) + 634 * 3) * M * M * 2 * 2 + M * 317 * 2 + (M * M - 1) * (2 * 2 - 1) * 41 + M$$

$$* 41 + (M - 1) * 41) \cdot N \cdot k = 129700 \cdot N \ gates$$

Thereby, the complexity of the UDPD methods of the present disclosure, especially the optimized one, is much closer to the low complexity of the known DPD method of the first type (DPD-1) that operates on 1 SPS signals, than to the high complexity of the known DPD method of the second type (DPD-2) that operates on upsampled k SPS signals.

Finally, the performance of the UDPD methods of the present disclosure can be compared with the performance of the known DPD methods.

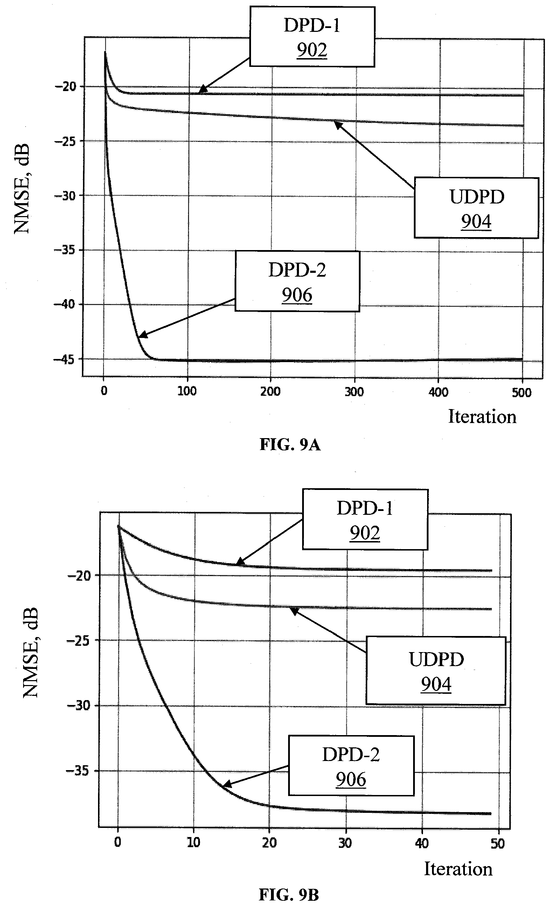

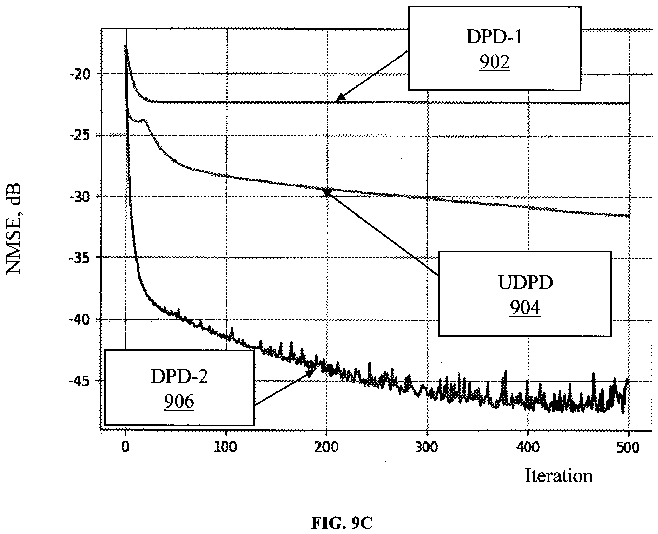

FIGS. 9A to 9C illustrate a comparative data on the performance of the known digital predistortion methods, DPD-1 and DPD-2, and the optimized UDPD method of the disclosure with different predistortion upsampling factors (simply the upsampling factors in the known methods) k = 1.5 (FIG. 7A), 1.25 (FIG. 7B) and 2.0 (FIG. 7C).

For the comparative analysis, the known DPD-1 and DPD-2 methods have been implemented as follows. In an implementation of the DPD-1 method, an input signal sampled at 1 SPS rate is subject to, in a transmitter chain, the predistortion processing, the upsampling to k SPS sampling rate, and the feed-forward digital PE, all that in sequence. The k SPS signal is transmitted via an optical channel and, in a receiver chain, is subject to the RRC filtering, the FIR filtering and the downsampling to 1 SPS sampling rate. Said downsampled, 1 SPS signal is fed back to the transmitter chain as a feedback error signal for adaptation of the predistortion algorithm.

An implementation of the DPD-2 method differs from the DPD-1 one described above in that the 1 SPS input signal is at first upsampled to k SPS sampling rate and then subject to the predistortion and the PE processing which are made in parallel. In the received chain, the signal is fed back to the transmitter chain before the downsampling to provide a k SPS feedback error signal for adaptation of the predistortion algorithm.

A communication system with the UDPD apparatus for predistortion of the digital signal in a transmitter chain that can be used for an implementation of the optimized UPDP method is shown in FIG. 6A, with the UDPD apparatus structure illustrated in FIG. 1B. Correspondingly, in an implementation of the optimized UDPD method, the 1 SPS input signal is decompressed into k_down subsets or phases, as shown in FIG. 2A, while the k SPS feedback error signal is decompressed into k_up subsets or phases, as shown in FIG. 3A. For this comparative analysis, the optimized UDPD processing has been implemented by means of the non-linear spline model with calculating the spline functions using the lookup tables as described above and illustrated in FIG. 4B.

FIGS. 7a to 7C show the performance of each of the predistortion methods in the analysis, which is defined by a normalized mean square error, NMSE, in dB, between a desired signal and an output signal, depending on iterations of the predistortion algorithm. It can be seen that in each case the performance of the optimized UDPD method is in between the performances of the known methods, surpassing the DPD-1 method which also operates on 1 SPS signals.

## Claims

1. A method of predistortion of a digital signal in a transmitter chain, comprising:

    obtaining an input signal (202) sampled at a first sampling rate;
    decomposing the input signal (202) into k_down input signal subsets of equal length L by sequentially assigning each k_down-th sample of the input signal (202), starting with an l-th sample, to an l-th input signal subset in ascending order of sample number, wherein L, k down and l are integers, l being from 1 to k_down;
    generating k down model input signal subsets of equal length L, by applying a non-linear model to each of the k_down input signal subsets;
    generating k_up predistortion signal subsets of equal length L, wherein each predistortion signal subset is generated by combining the k_down model input signal subsets, each model input signal subset being multiplied by an adaptation coefficient, wherein k_up is an integer greater than k down; and
    generating a predistortion signal with a second sampling rate which is k_up/k_down times the first sampling rate, by sequentially assigning one sample from each predistortion signal subset, in ascending order of subset number, from 1 to k_up, to the predistortion signal until all samples of the k_up predistortion signal subsets are assigned.

2. The method of claim 1, further comprising:

    obtaining an error signal (206) sampled at the second sampling rate;
    decompressing the error signal (206) into k_up error signal subsets of equal length L by sequential assigning each k_up-th sample of the error signal (206), starting with an p-th sample, to an p-th error signal subset in ascending order of sample number, p being from 1 to k_up; and
    calculating k_up*k_down adaptation coefficients for the k_down model input signal subsets on the basis of the k_up error signal subsets.

3. The method of claim 1 or 2, wherein each predistortion signal subset is generated by summing up the k_down model input signal subsets, each model input signal subset being multiplied by an adaptation coefficient.

4. The method of claim 1 or 2, further comprising determining, for each predistortion signal subset, the biggest adaptation coefficient among k down adaptation coefficients of the k_down model input signal subsets to be combined for generating the given predistortion signal subset, and selecting a model input signal subset with the biggest adaptation coefficient as an only term that contributes to the given predistortion signal subset.

5. The method of any of claims 1 to 4, wherein the first sampling rate is 1 sample per second, SPS.

6. The method of claim 5, wherein the non-liner model is a non-linear spline model.

7. The method of claim 6, wherein the applying of the non-linear spline model comprises calculating spline functions using lookup tables.

8. An apparatus (100) for predistortion of a digital signal in a transmitter chain, comprising:

   a feeder (102) configured for obtaining an input signal (202) sampled at a first sampling rate;
   a decomposer (104) configured for decomposing the input signal (202) into k_down input signal subsets of equal length L by sequentially assigning each k_down-th sample of the input signal (202), starting with an l-th sample, to an l-th input signal subset in ascending order of sample number, wherein L, k down and l are integers, l being from 1 to k_down;
   an evaluator (106) configured for generating k down model input signal subsets of equal length L, by applying a non-linear model to each of the k_down input signal subsets;
   a predistortion unit (108) configured for generating k_up predistortion signal subsets of equal length L, wherein each predistortion signal subset is generated by combining the k_down model input signal subsets, each model input signal subset being multiplied by an adaptation coefficient, wherein k_up is an integer greater than k down; and
   a composer (110) configured for generating a predistortion signal (408) with a second sampling rate which is k_up/k_down times the first sampling rate, by sequentially assigning one sample from each predistortion signal subset, in ascending order of subset number, from 1 to k_up, to the predistortion signal (408) until all samples of the k_up predistortion signal subsets are assigned.

9. The apparatus (100) of claim 8, further comprising:

   a feedback feeder (112) configured for obtaining an error signal (206) sampled at the second sampling rate; and
   a feedback decomposer (114) configured for decompressing the error signal (206) into k_up error signal subsets of equal length L by sequential assigning each k_up-th sample of the error signal (206), starting with an p-th sample, to an p-th error signal subset in ascending order of sample number, p being from 1 to k_up;
   wherein the predistortion unit (108) is further configured for calculating k_up*k down adaptation coefficients for the k_down model input signal subsets on the basis of the k_up error signal subsets.

10. The apparatus (100) of claim 9, wherein the feedback feeder (112) is configured for

   receiving an upsampled input signal having the second sampling rate from an upsampling unit, and a feedback signal sampled at the second sampling rate from a receiver chain, and
   summing up the upsampled input signal with the inverted feedback signal to obtain the error signal (206) sampled at the second sampling rate.

11. The apparatus (100) of claim 9, wherein the feedback feeder (112) is configured for

   receiving the input signal having the first sampling rate from the feeder (102) and a feedback signal sampled at the first sampling rate from a receiver chain,
   summing up the input signal with the inverted feedback signal, each having the first sampling rate, to obtain the error signal having the first sampling rate, and
   upsampling the error signal to the second sampling rate to obtain the error signal (206) sampled at the second sampling rate.

12. The apparatus (100) of any of claims 8 to 11, wherein the predistortion unit (108) is configured for generating each predistortion signal subset by summing up the k_down model input signal subsets, each model input signal subset being multiplied by an adaptation coefficient.

13. The apparatus (100) of any of claims 8 to 11, wherein the predistortion unit (108) is configured for

   determining, for each predistortion signal subset, the biggest adaptation coefficient among k_down adaptation coefficients of the k_down model input signal subsets to be combined for generating the given predistortion signal subset, and

   selecting a model input signal subset with the biggest adaptation coefficient as an only term that contributes to the given predistortion signal subset.

14. The apparatus (100) of any of claims 8 to 13, wherein the first sampling rate is 1 sample per second, SPS.

15. The apparatus (100) of claim 14, wherein the evaluator (106) is configured for applying a non-linear spline model.


**Patentansprüche**

1. Verfahren zur Vorverzerrung eines digitalen Signals in einer Senderkette, umfassend:

   Erlangen eines Eingabesignals (202), das mit einer ersten Samplingrate gesampelt wird;
   Zerlegen des Eingabesignals (202) in k_down-Eingabesignalteilsätze gleicher Länge L durch sequenzielles Zuweisen jedes k_down-ten Samples des Eingabesignals (202), beginnend mit einem l-ten Sample, zu einem l-ten Eingabesignalteilsatz in aufsteigender Reihenfolge der Samplenummer, wobei L, k_down und l Ganzzahlen sind und l von 1 bis k_down reicht;
   Erzeugen von k_down-Modelleingabesignalteilsätzen gleicher Länge L durch Anwenden eines nichtlinearen Modells auf jeden der k_down-Eingabesignalteilsätze;
   Erzeugen von k_up-Vorverzerrungssignalteilsätzen gleicher Länge L, wobei jeder Vorverzerrungssignalteilsatz durch Kombinieren der k_down-Modelleingabesignalteilsätze erzeugt wird, wobei jeder Modelleingabesignalteilsatz mit einem Anpassungskoeffizienten multipliziert wird, wobei k_up eine Ganzzahl größer als k_down ist; und
   Erzeugen eines Vorverzerrungssignals mit einer zweiten Samplingrate, die ein k_up/k_down-Faches der ersten Samplingrate ist, durch sequenzielles Zuweisen eines Samples aus jedem Vorverzerrungssignalteilsatz in aufsteigender Reihenfolge der Teilsatznummer von 1 bis k_up zu dem Vorverzerrungssignal, bis alle Samples der k_up-Vorverzerrungssignalteilsätze zugewiesen sind.

2. Verfahren nach Anspruch 1, ferner umfassend:

   Erlangen eines Fehlersignals (206), das mit der zweiten Samplingrate gesampelt wird;
   Dekomprimieren des Fehlersignals (206) in k_up-Fehlersignalteilsätze gleicher Länge L durch sequentielles Zuweisen jedes k_up-ten Samples des Fehlersignals (206), beginnend mit einem p-ten Sample, zu einem p-ten Fehlersignalteilsatz in aufsteigender Reihenfolge der Samplenummer, wobei p von 1 bis k_up reicht; und
   Berechnen von k_up*k_down-Anpassungskoeffizienten für die k_down-Modelleingabesignalteilsätze basierend auf den k_up-Fehlersignalteilsätzen.

3. Verfahren nach Anspruch 1 oder 2, wobei jeder Vorverzerrungssignalteilsatz durch Summieren der k_down-Modelleingabesignalteilsätze erzeugt wird, wobei jeder Modelleingabesignalteilsatz mit einem Anpassungskoeffizienten multipliziert wird.

4. Verfahren nach Anspruch 1 oder 2, ferner umfassend Bestimmen, für jeden Vorverzerrungssignalteilsatz, des größten Anpassungskoeffizienten unter k_down-Anpassungskoeffizienten der k_down-Modelleingabesignalteilsätze, die zum Erzeugen des gegebenen Vorverzerrungssignalteilsatzes zu kombinieren sind, und Auswählen eines Modelleingabesignalteilsatzes mit dem größten Anpassungskoeffizienten als einen einzigen Term, der zu dem gegebenen Vorverzerrungssignalteilsatz beiträgt.

5. Verfahren nach einem der Ansprüche 1 bis 4, wobei die erste Samplingrate 1 Sample pro Sekunde, SPS, ist.

6. Verfahren nach Anspruch 5, wobei das nichtlineare Modell ein nichtlineares Splinemodell ist.

7. Verfahren nach Anspruch 6, wobei das Anwenden des nichtlinearen Splinemodells Berechnen von Splinefunktionen unter Verwendung von Lookup-Tabellen umfasst.

8. Vorrichtung (100) zur Vorverzerrung eines digitalen Signals in einer Senderkette, umfassend:

einen Zuführer (102), der zum Erlangen eines Eingabesignals (202) konfiguriert ist, das mit einer ersten Samplingrate gesampelt wird;

einen Zerleger (104), der zum Zerlegen des Eingabesignals (202) in k_down-Eingabesignalteilsätze gleicher Länge L durch sequenzielles Zuweisen jedes k_down-ten Samples des Eingabesignals (202), beginnend mit einem l-ten Sample, zu einem l-ten Eingabesignalteilsatz in aufsteigender Reihenfolge der Samplenummer konfiguriert ist, wobei L, k_down und l Ganzzahlen sind und l von 1 bis k_down reicht;

einen Auswerter (106), der zum Erzeugen von k_down-Modelleingabesignalteilsätzen gleicher Länge L durch Anwenden eines nichtlinearen Modells auf jeden der k_down-Eingabesignalteilsätze konfiguriert ist;

eine Vorverzerrungseinheit (108), die zum Erzeugen von k_up-Vorverzerrungssignalteilsätzen gleicher Länge L konfiguriert ist, wobei jeder Vorverzerrungssignalteilsatz durch Kombinieren der k_down-Modelleingabesignalteilsätze erzeugt wird, wobei jeder Modelleingabesignalteilsatz mit einem Anpassungskoeffizienten multipliziert wird, wobei k_up eine Ganzzahl größer als k_down ist; und

eine Komponiereinrichtung (110), die zum Erzeugen eines Vorverzerrungssignals (408) mit einer zweiten Samplingrate, die ein k_up/k_down-Faches der ersten Samplingrate ist, durch sequenzielles Zuweisen eines Samples aus jedem Vorverzerrungssignalteilsatz in aufsteigender Reihenfolge der Teilsatznummer von 1 bis k_up zu dem Vorverzerrungssignal (408) konfiguriert ist, bis alle Samples der k_up-Vorverzerrungssignalteilsätze zugewiesen sind.

9. Vorrichtung (100) nach Anspruch 8, ferner umfassend:

einen Rückkopplungszuführer (112), der zum Erlangen eines Fehlersignals (206) konfiguriert ist, das mit der zweiten Samplingrate gesampelt wird; und

einen Rückkopplungszerleger (114), der zum Dekomprimieren des Fehlersignals (206) in k_up-Fehlersignalteilsätze gleicher Länge L durch sequentielles Zuweisen jedes k_up-ten Samples des Fehlersignals (206), beginnend mit einem p-ten Sample, zu einem p-ten Fehlersignalteilsatz in aufsteigender Reihenfolge der Samplenummer konfiguriert ist, wobei p von 1 bis k_up reicht;

wobei die Vorverzerrungseinheit (108) ferner zum Berechnen von k_up*k_down-Anpassungskoeffizienten für die k_down-Modelleingabesignalteilsätze basierend auf den k_up-Fehlersignalteilsätzen konfiguriert ist.

10. Vorrichtung (100) nach Anspruch 9, wobei der Rückkopplungszuführer (112) zu Folgendem konfiguriert ist:

Empfangen eines upgesampelten Eingabesignals, das die zweite Samplingrate aufweist, von einer Upsamplingeinheit und eines Rückkopplungssignals, das mit der zweiten Samplingrate gesampelt wird, von einer Empfängerkette und

Summieren des upgesampelten Eingabesignals mit dem invertierten Rückkopplungssignal, um das Fehlersignal (206) zu erlangen, das mit der zweiten Samplingrate gesampelt wird.

11. Vorrichtung (100) nach Anspruch 9, wobei der Rückkopplungszuführer (112) zu Folgendem konfiguriert ist:

Empfangen des Eingabesignals, das die erste Samplingrate aufweist, von dem Zuführer (102) und eines Rückkopplungssignals, das mit der ersten Samplingrate gesampelt wird, von einer Empfängerkette,

Summieren des Eingabesignals mit dem invertierten Rückkopplungssignal, wobei jedes die erste Samplingrate aufweist, um das Fehlersignal zu erlangen, das die erste Samplingrate aufweist, und

Upsampeln des Fehlersignals auf die zweite Samplingrate, um das Fehlersignal (206) zu erlangen, das mit der zweiten Samplingrate gesampelt wird.

12. Vorrichtung (100) nach einem der Ansprüche 8 bis 11, wobei die Vorverzerrungseinheit (108) zum Erzeugen jedes Vorverzerrungssignalteilsatzes durch Summieren der k_down-Modelleingabesignalteilsätze konfiguriert ist, wobei jeder Modelleingabesignalteilsatz mit einem Anpassungskoeffizienten multipliziert wird.

13. Vorrichtung (100) nach einem der Ansprüche 8 bis 11, wobei die Vorverzerrungseinheit (108) zu Folgendem konfiguriert ist:

Bestimmen, für jeden Vorverzerrungssignalteilsatz, des größten Anpassungskoeffizienten unter k_down-Anpassungskoeffizienten der k_down-Modelleingabesignalteilsätze, die zum Erzeugen des gegebenen Vorverzerrungssignalteilsatzes zu kombinieren sind, und Auswählen eines Modelleingabesignalteilsatzes mit dem größten Anpassungskoeffizienten als einen einzigen Term, der zu dem gegebenen Vorverzerrungssignalteilsatz beiträgt.

**14.** Vorrichtung (100) nach einem der Ansprüche 8 bis 13, wobei die erste Samplingrate 1 Sample pro Sekunde, SPS, ist.

**15.** Vorrichtung (100) nach Anspruch 14, wobei der Auswerter (106) zum Anwenden eines nichtlinearen Splinemodells konfiguriert ist.

**Revendications**

**1.** Procédé de prédistorsion d'un signal numérique dans une chaîne d'émetteurs, comprenant :

l'obtention d'un signal d'entrée (202) échantillonné à un premier taux d'échantillonnage ;
la décomposition du signal d'entrée (202) en sous-ensembles de signaux d'entrée k_down de longueur égale L en attribuant séquentiellement chaque k_down-ième échantillon du signal d'entrée (202), en commençant par un l-ième échantillon, à un l-ième sous-ensemble de signaux d'entrée dans l'ordre croissant du numéro d'échantillon, dans lequel L, k_down et l sont des nombres entiers, l allant de 1 à k_down ;
la génération de sous-ensembles de signaux d'entrée de modèle k_down de longueur égale L, en appliquant un modèle non linéaire à chacun des sous-ensembles de signaux d'entrée k_down ;
la génération de sous-ensembles de signaux de prédistorsion k_up de longueur égale L, dans lequel chaque sous-ensemble de signaux de prédistorsion est généré en combinant les sous-ensembles de signaux d'entrée de modèle k_down, chaque sous-ensemble de signaux d'entrée de modèle étant multiplié par un coefficient d'adaptation, dans lequel k_up est un nombre entier supérieur à k_down ; et
la génération d'un signal de prédistorsion avec un second taux d'échantillonnage qui est k_up/k_down fois le premier taux d'échantillonnage, en attribuant séquentiellement un échantillon de chaque sous-ensemble de signaux de prédistorsion, dans l'ordre croissant du numéro de sous-ensemble, de 1 à k_up, au signal de prédistorsion jusqu'à ce que tous les échantillons des sous-ensembles de signaux de prédistorsion k_up soient attribués.

**2.** Procédé selon la revendication 1, comprenant également :

l'obtention d'un signal d'erreur (206) échantillonné au second taux d'échantillonnage ;
la décompression du signal d'erreur (206) en sous-ensembles de signaux d'erreur k_up de longueur égale L en attribuant séquentiellement chaque k_up-ième échantillon du signal d'erreur (206), en commençant par un p-ième échantillon, à un p-ième sous-ensemble de signaux d'erreur dans l'ordre croissant du numéro d'échantillon, p allant de 1 à k_up ; et
le calcul de coefficients d'adaptation k_up*k_down pour les sous-ensembles de signaux d'entrée de modèle k_down sur la base des sous-ensembles de signaux d'erreur k_up.

**3.** Procédé selon la revendication 1 ou 2, dans lequel chaque sous-ensemble de signaux de prédistorsion est généré en additionnant les sous-ensembles de signaux d'entrée de modèle k_down, chaque sous-ensemble de signaux d'entrée de modèle étant multiplié par un coefficient d'adaptation.

**4.** Procédé selon la revendication 1 ou 2, comprenant également la détermination, pour chaque sous-ensemble de signaux de prédistorsion, du plus grand coefficient d'adaptation parmi les coefficients d'adaptation k_down des sous-ensembles de signaux d'entrée de modèle k_down à combiner pour générer le sous-ensemble de signaux de prédistorsion donné, et la sélection d'un sous-ensemble de signaux d'entrée de modèle avec le plus grand coefficient d'adaptation comme seul terme qui contribue au sous-ensemble de signaux de prédistorsion donné.

**5.** Procédé selon l'une quelconque des revendications 1 à 4, dans lequel le premier taux d'échantillonnage est de 1 échantillon par seconde, SPS.

**6.** Procédé selon la revendication 5, dans lequel le modèle non linéaire est un modèle spline non linéaire.

**7.** Procédé selon la revendication 6, dans lequel l'application du modèle spline non linéaire comprend le calcul de fonctions splines à l'aide de tables de correspondance.

**8.** Appareil (100) de prédistorsion d'un signal numérique dans une chaîne d'émetteurs, comprenant :

un dispositif d'alimentation (102) configuré pour obtenir un signal d'entrée (202) échantillonné à un premier taux d'échantillonnage ;

un décomposeur (104) configuré pour décomposer le signal d'entrée (202) en sous-ensembles de signaux d'entrée k_down de longueur égale L en attribuant séquentiellement chaque k_down-ième échantillon du signal d'entrée (202), en commençant par un l-ième échantillon, à un l-ième sous-ensemble de signaux d'entrée dans l'ordre croissant du numéro d'échantillon, dans lequel L, k_down et l sont des nombres entiers, l allant de 1 à k_down ;

un évaluateur (106) configuré pour la génération de sous-ensembles de signaux d'entrée de modèle k_down de longueur égale L, en appliquant un modèle non linéaire à chacun des sous-ensembles de signaux d'entrée k_down ;

une unité de prédistortion (108) configurée pour la génération de sous-ensembles de signaux de prédistorsion k_up de longueur égale L, dans lequel chaque sous-ensemble de signaux de prédistorsion est généré en combinant les sous-ensembles de signaux d'entrée de modèle k_down, chaque sous-ensemble de signaux d'entrée de modèle étant multiplié par un coefficient d'adaptation, dans lequel k_up est un nombre entier supérieur à k_down ; et

un composeur (110) configuré pour la génération d'un signal de prédistorsion (408) avec un second taux d'échantillonnage qui est k_up/k_down fois le premier taux d'échantillonnage, en attribuant séquentiellement un échantillon de chaque sous-ensemble de signaux de prédistorsion, dans l'ordre croissant du numéro de sous-ensemble, de 1 à k_up, au signal de prédistorsion (408) jusqu'à ce que tous les échantillons des sous-ensembles de signaux de prédistorsion k_up soient attribués.

9.  Appareil (100) selon la revendication 8, comprenant également :

un dispositif d'alimentation de rétroaction (112) configuré pour obtenir un signal d'erreur (206) échantillonné au second taux d'échantillonnage ; et

un décomposeur de rétroaction (114) configuré pour la décompression du signal d'erreur (206) en sous-ensembles de signaux d'erreur k_up de longueur égale L en attribuant séquentiellement chaque k_up-ième échantillon du signal d'erreur (206), en commençant par un p-ième échantillon, à un p-ième sous-ensemble de signaux d'erreur dans l'ordre croissant du numéro d'échantillon, p allant de 1 à k_up ;

dans lequel l'unité de prédistorsion (108) est également configurée pour calculer des coefficients d'adaptation k_up*k_down pour les sous-ensembles de signaux d'entrée de modèle k_down sur la base des sous-ensembles de signaux d'erreur k_up.

10. Appareil (100) selon la revendication 9, dans lequel le dispositif d'alimentation de rétroaction (112) est configuré pour la réception d'un signal d'entrée suréchantillonné ayant le second taux d'échantillonnage à partir d'une unité de suréchantillonnage, et un signal de rétroaction échantillonné au second taux d'échantillonnage à partir d'une chaîne de récepteurs, et

l'addition du signal d'entrée suréchantillonné avec le signal de rétroaction inversé pour obtenir le signal d'erreur (206) échantillonné au second taux d'échantillonnage.

11. Appareil (100) selon la revendication 9, dans lequel le dispositif d'alimentation de rétroaction (112) est configuré pour recevoir le signal d'entrée ayant le premier taux d'échantillonnage provenant du dispositif d'alimentation (102) et un signal de rétroaction échantillonné au premier taux d'échantillonnage provenant d'une chaîne de récepteurs,

additionner le signal d'entrée avec le signal de rétroaction inversé, chacun ayant le premier taux d'échantillonnage, pour obtenir le signal d'erreur ayant le premier taux d'échantillonnage, et

suréchantillonner le signal d'erreur au second taux d'échantillonnage pour obtenir le signal d'erreur (206) échantillonné au second taux d'échantillonnage.

12. Appareil (100) selon l'une quelconque des revendications 8 à 11, dans lequel l'unité de prédistorsion (108) est configurée pour générer chaque sous-ensemble de signaux de prédistorsion en additionnant les sous-ensembles de signaux d'entrée de modèle k_down, chaque sous-ensemble de signaux d'entrée de modèle étant multiplié par un coefficient d'adaptation.

13. Appareil (100) selon l'une quelconque des revendications 8 à 11, dans lequel l'unité de prédistorsion (108) est configurée pour

déterminer, pour chaque sous-ensemble de signaux de prédistorsion, le plus grand coefficient d'adaptation parmi les coefficients d'adaptation k_down des sous-ensembles de signaux d'entrée du modèle k_down à combiner pour générer le sous-ensemble de signaux de prédistorsion donné, et

sélectionner un sous-ensemble de signaux d'entrée de modèle avec le plus grand coefficient d'adaptation comme seul terme qui contribue au sous-ensemble de signaux de prédistorsion donné.

14. Appareil (100) selon l'une quelconque des revendications 8 à 13, dans lequel le premier taux d'échantillonnage est de 1 échantillon par seconde, SPS.

15. Appareil (100) selon la revendication 14, dans lequel l'évaluateur (106) est configuré pour appliquer un modèle de spline non linéaire.

FIG. 1A

EP 4 278 482 B1

**FIG. 1B**

EP 4 278 482 B1

x_in$_1$

| 1 |
| :---: |
| 1+k_down |
| 1+2*k_down |
| ... |
| N-(k_down-1) |

204A

x_in

202

| 1 |
| :---: |
| 2 |
| ... |
| N-2 |
| N-1 |
| N |

| 2 |
| :---: |
| 2+k_down |
| 2+2*k_down |
| ... |
| N-(k_down-2) |

x_in$_2$

204B

...

...

| k_down |
| :---: |
| 2*k_down |
| 3*k_down |
| ... |
| N |

x_in$_{k\_down}$

204C

**FIG. 2A**

**FIG. 2B**

error

302A

| 1 |
| 2 |
| 3 |
| 4 |
| 5 |
| 6 |
| 7 |
| 8 |
| ... |
| k*N-2 |
| k*N-1 |
| k*N |

$e_1$

304C

| 1 |
| 4 |
| 7 |
| ... |
| k*N-2 |

$e_2$

304D

| 2 |
| 5 |
| 8 |
| ... |
| k*N-1 |

$e_3$

304E

| 3 |
| 6 |
| 9 |
| ... |
| k*N |

**FIG. 3B**

FIG. 4A

EP 4 278 482 B1

**FIG. 4B**

**FIG. 5**

x(n)

Transmitter
602

Upsampling module
608

e(n)

UDPD
apparatus
606

Digital pre-emphasis
module
610

Optical Channel
612

Receiver 604

RRC filter module
614

Adaptive FIR filter
module
616

y(n)

Down-sampling
module 618

z(n)

**FIG. 6A**

x(n)

Transmitter
602

e(n)

Upsampling
module
620

UDPD
apparatus
606

Upsampling
module
608

Digital pre-
emphasis module
610

Optical Channel
612

Receiver 604

RRC filter
module
614

Adaptive FIR
filter module
616

Down-sampling
module 618

z(n)

**FIG. 6B**

Obtaining an input signal sampled at first sampling rate
702

Decomposing the input signal into k_down input signal subsets of equal length L by sequentially assigning each k_down-th sample of the input signal, starting with an l-th sample, to an l-th input signal subset in ascending order of sample number, l being from 1 to k_down
704

Generating k_down model input signal subsets of equal length L by applying a non-linear model to each of the k_down input signal subsets
706

Generating k_up predistortion signal subsets of equal length L, wherein each predistortion signal subset is generated by combining the k_down model input signal subsets multiplied each by an adaptation coefficient, k_up being an integer greater than k_down
708

Generating a predistortion signal with a second sampling rate which is k_up/k_down times the first sampling rate, by sequentially assigning one sample from each predistortion signal subset, in ascending order of subset number, from 1 to k_up, to the predistortion signal until all samples of the k_up predistortion signal subsets are assigned
710

**FIG. 7**

Obtaining an input signal sampled at first sampling rate
802

Decomposing the input signal into k_down input signal subsets of equal length L by sequentially assigning each k_down-th sample of the input signal, starting with an l-th sample, to an l-th input signal subset in ascending order of sample number, l being from 1 to k_down
804

Generating k_down groups of 3 model input signal subsets of equal length L by applying a non-linear spline model to every input signal subset to generate a group of 3 model input signal subsets from every input signal subset
806

Generating k_up predistortion signal subsets of equal length L; each predistortion signal subset is generated by combining the k_down groups of 3 model input signal subsets, each model input signal subset being multiplied by an adaptation coefficient, k_up being an integer greater than k_down
808

Generating a predistortion signal with a second sampling rate which is k_up/k_down times the first sampling rate by sequentially assigning one sample from each predistortion signal subset, in ascending order of subset number, from 1 to k_up, to the predistortion signal until all samples of the k_up predistortion signal subsets are assigned
810

**FIG. 8**

**FIG. 9A**

**FIG. 9B**

**FIG. 9C**

**REFERENCES CITED IN THE DESCRIPTION**

**Patent documents cited in the description**

- US 20050195919 A1

- EP 3457594 A1